(19) **Europäisches Patentamt / European Patent Office / Office européen des brevets**

(11) **EP 1 523 078 B1**

(12) **EUROPEAN PATENT SPECIFICATION**

(45) Date of publication and mention
of the grant of the patent:
**09.05.2007 Bulletin 2007/19**

(51) Int Cl.:
*H01S 5/042* (2006.01)     *H04B 10/04* (2006.01)

(21) Application number: **03764178.4**

(22) Date of filing: **11.07.2003**

(86) International application number:
**PCT/JP2003/008859**

(87) International publication number:
**WO 2004/008594 (22.01.2004 Gazette 2004/04)**

(54) **OPTICAL SEMICONDUCTOR DEVICE**

OPTISCHES HALBLEITERBAUELEMENT

DISPOSITIF SEMI-CONDUCTEUR OPTIQUE

(84) Designated Contracting States:
**DE FR GB IT**

(30) Priority: **12.07.2002 JP 2002204782**

(43) Date of publication of application:
**13.04.2005 Bulletin 2005/15**

(73) Proprietor: **MITSUBISHI ELECTRIC CORPORATION**
**Chiyoda-ku**
**Tokyo 100-8310 (JP)**

(72) Inventors:
• **ARUGA, Hiroshi**
  **c/o Mitsubishi Denki K. K.**
  **Chiyoda-ku, Tokyo 100-8310 (JP)**
• **KANEKO, Shinichi**
  **c/o Mitsubishi Denki K. K.**
  **Chiyoda-ku, Tokyo 100-8310 (JP)**
• **SAKAI, Kiyohide**
  **c/o Mitsubishi Denki K. K.**
  **Chiyoda-ku, Tokyo 100-8310 (JP)**

(74) Representative: **Nicholls, Michael John**
**J.A. KEMP & CO.**
**14, South Square**
**Gray's Inn**
**London WC1R 5JJ (GB)**

(56) References cited:
JP-A- 9 283 825     JP-A- 11 233 876
US-A- 5 371 755     US-A- 5 646 763
US-A- 5 771 220

• NAGAHORI T ET AL: "AN ANALOG FRONT-END CHIP SET EMPLOYING AN ELECTRO-OPTICAL MIXED DESIGN ON SPICE FOR 5-GB/S/CG PARALLEL OPTICAL INTERCONNECTION" IEEE JOURNAL OF SOLID-STATE CIRCUITS, IEEE SERVICE CENTER, PISCATAWAY, NJ, US, vol. 36, no. 12, December 2001 (2001-12), pages 1984-1991, XP001222521 ISSN: 0018-9200
• PATENT ABSTRACTS OF JAPAN vol. 012, no. 066 (P-671), 27 February 1988 (1988-02-27) & JP 62 206570 A (CITIZEN WATCH CO LTD), 11 September 1987 (1987-09-11)
• PATENT ABSTRACTS OF JAPAN vol. 2002, no. 08, 5 August 2002 (2002-08-05) & JP 2002 111118 A (HITACHI CABLE LTD), 12 April 2002 (2002-04-12)
• PATENT ABSTRACTS OF JAPAN vol. 1997, no. 06, 30 June 1997 (1997-06-30) & JP 09 055630 A (HITACHI LTD; HITACHI VLSI ENG CORP), 25 February 1997 (1997-02-25)
• SAKAI K ET AL OPTICAL SOCIETY OF AMERICA / INSTITUTE OF ELECTRICAL AND ELECTRONICS ENGINEERS: "A coaxial DFB laser-diode module with a differential feed for 10-Gb/s ethernet applications" OPTICAL FIBER COMMUNICATION CONFERENCE. (OFC). POSTCONFERENCE DIGEST. ATLANTA, GA, MARCH 23 - 28, 2003, TRENDS IN OPTICS AND PHOTONICS SERIES. (TOPS), WASHINGTON, DC : OSA, US, vol. TOPS. VOL. 86, 23 March 2003 (2003-03-23), pages 679-680, XP010680425 ISBN: 1-55752-746-6

**Description**

TECHNICAL FIELD

The present invention relates to an optical semiconductor device including an optical semiconductor element that outputs an optical signal modulated based on an electric signal.

BACKGROUND ART

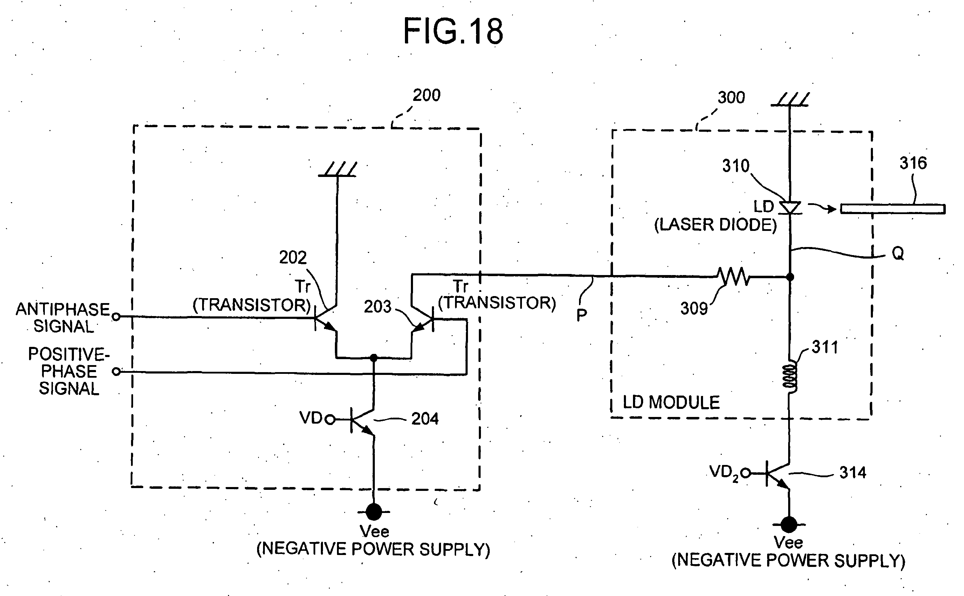

Fig. 18 is a circuit diagram which illustrates one example of a conventional single-phase feed type optical semiconductor device. Circuits similar to such a circuit are disclosed by, for example, Japanese Patent Application Laid-Open Publication Nos. 9-200150 and 8-172401.

In the optical semiconductor device shown in Fig. 18, an LD driving circuit 200 that drives a semiconductor laser diode element 310 (hereinafter, "LD") is connected to an LD module 300. A light emission output of the LD 310 is output from an optical fiber 316. Differential transistors 202 and 203, which constitute a differential amplifier are driven by a constant current by a transistor 204, are applied with complementary data input signals (a positive phase signal and an antiphase signal), respectively, and output a positive-phase signal. A collector of the differential transistor 202 is grounded. A collector of the differential transistor 203 is connected to one end of a damping resistor 309, and the other end of the damping resistor 309 is connected to one electrode (cathode) of the LD 310. The cathode of the LD 310 is connected to one end of an inductance element 311 having a high impedance with respect to a high frequency, such as a chip inductance. The other end of the inductance element 311 is connected to a constant current source 314 that supplies a bias current to the LD 310. The inductance element 311 constitutes a bias circuit for the LD module 300.

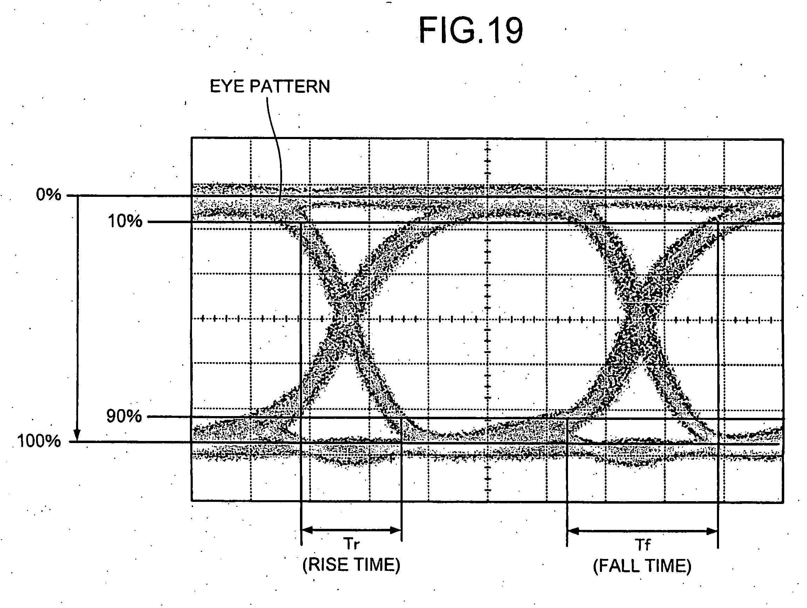

Fig. 19 illustrates one example of an eye pattern of electric signal waveforms output from a circuit such as the LD driving circuit 200 shown in Fig. 18. The LD driving circuit illustrated in this example employs a silicon-germanium semiconductor so as to reduce power consumption of the circuit.

If this LD driving circuit is driven by a negative voltage as shown in Fig. 18, a first transition of an electric signal pulse corresponding to a first transition of an optical signal pulse is a segment of the eye pattern directed downward whereas a second transition thereof is a segment of the eye pattern directed upward. As shown in Fig. 19, a fall time Tf is longer than a rise time Tr by about 40 percents.

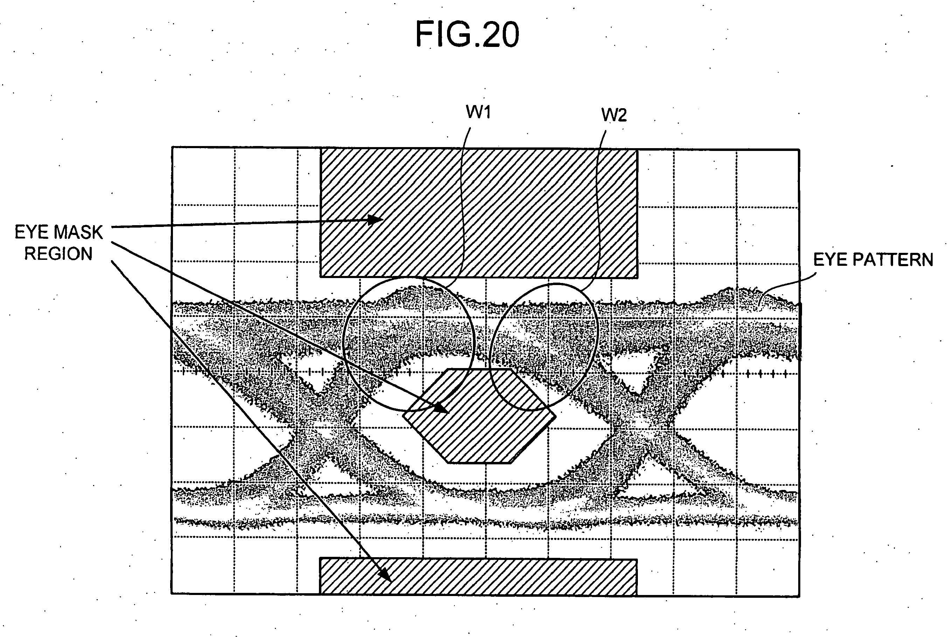

Fig. 20 illustrates one example of an eye pattern of optical signal waveforms (optical output waveforms) output from the LD module shown in Fig. 18 using the LD driving circuit that outputs electric signals having signal waveforms as shown in Fig. 19. This example illustrates that optical signal waveforms in various patterns are photoelectrically converted to electric signals and that the electric signals are overlaid through a band filter. In Fig. 20, an upper part is a mark side (light emission) and the horizontal axis indicates time. Fig. 20 also illustrates eye mask regions (regions which are an index to determination as to whether a signal is deteriorated and in which the eye pattern should not enter).

Eye mask prescription indicated by the eye mask regions are an index to the performance of the signal waveform. As a gap (an eye mask margin) between the signal waveform (eye pattern) and the eye mask region is wider, better reception sensitivity characteristics can be attained when an optical receiver receives a signal. In other words, even if an optical signal is lower in power, error occurs less frequently and good transmission characteristics can be ensured.

That is, in order to obtain a signal at a low error rate when the optical signal output from the optical semiconductor device is received and converted to an electric signal and the electric signal is reproduced, it is necessary to prevent the eye pattern from entering the eye mask regions.

Nevertheless, if a modulated signal at 10 Gb/s or more is to be transmitted, the optical output waveform of the LD module is conspicuously deteriorated as shown in Fig. 20. As can be seen from the waveform shown in Fig. 20, there is an enough margin to the eye mask prescription near an upper left part of a central portion of the eye pattern (a rising part indicated by W1 in Fig. 20). However, the eye mask margin is quite small near an upper right part of the central portion (a rising part indicated by W2 in Fig. 20), with the result there is no margin at all to the eye mask prescription. Therefore, a problem occurs that if, for example, a surrounding temperature rises, a relaxation oscillation frequency of the optical semiconductor falls and the signal waveform cannot satisfy the upper right part of the central portion of the eye mask.

As can be seen, in the conventional optical semiconductor shown in Fig. 18, the margin to the eye mask prescription falls as shown in Fig. 20.

A cause for this fall of the eye margin is as follows. If the optical semiconductor device is a pulse intensity modulation type optical semiconductor device that modulates a light in a wide band from a low frequency band to a high frequency band, the fall time of the electric signal pulse is late as explained above and the eye mask margin that is a margin of the eye pattern falls due to asymmetry of the electric signal input to the LD module 300. As a result, the transmission characteristics of the optical signal to be output are deteriorated.

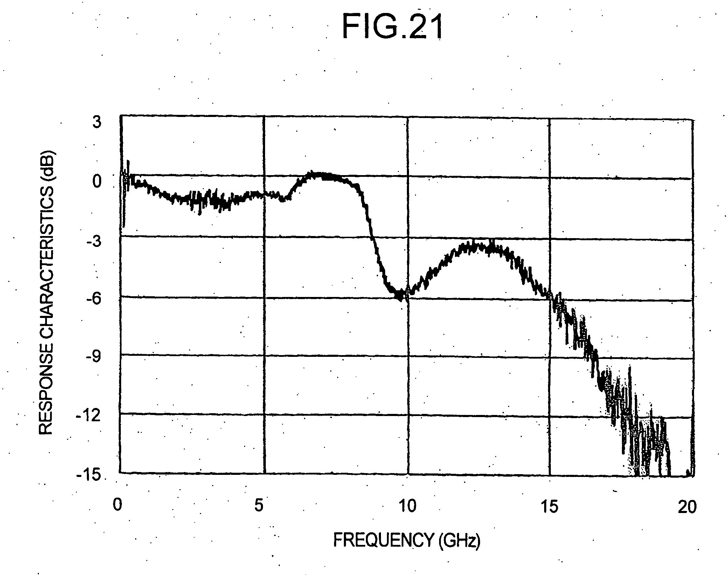

Fig. 21 is a frequency response graph if a signal transmission line P between the LD driving circuit 200 and the LD module 300 shown in Fig. 18 includes a distributed constant circuit such as a micro-strip line and if the LD module 300 is viewed from this distributed constant circuit. Fig. 21 demonstrates that a cutoff frequency (a frequency 3 decibels lower from a peak) is about 8.8 gigahertz and that there is a sharp decline of the response characteristics at a frequency near 10 gigahertz. Reasons for the presence of this sharp decline are as follows.

In a high frequency region such as a region at the frequency near 10 gigahertz, both ends of inductance element 311 shown in the example of Fig. 18 are fixed to a ceramic substrate and a plurality of pad sections each including a conductor are provided to arrange wirings by wire bonds. Since each pad section functions as a capacitance, a resonance is generated by these capacitances, a plurality of wires by the wire bonding that connect the LD 310 to pads provided between the inductance element 311 and the matching resistor 309, and a reactance component of the inductance element 311 that constitutes the bias circuit. This results in quite sharp damping characteristics.

As can be seen, the conventional optical semiconductor device has problems that output characteristics of the optical signal is influenced by poor fall characteristics of the LD driving circuit and the transmission characteristics of the optical signal is thereby deteriorated.

Further, the conventional optical semiconductor device has a problem that passing characteristics of the LD module suddenly attenuates at the frequency near 10 gigahertz. The sharp decline of the characteristics near 10 gigahertz particularly causes the great deterioration of the optical output waveform of the optical semiconductor device. It is significant to solve this problem.

JP-A-09-055630 and the paper: "An analog front-end chip set employing an electro-optical mixed design on SPICE for 5-Gb/s/ch parallel optical interconnection", IEEE Journal of solid state circuits, Vol. 36, No.12, pp 1984-1991 disclose optical semiconductor devices as defined by the pre-characterizing portion of claim 1.

It is, therefore, an object of the present invention to provide an optical semiconductor device which improves the deterioration of an optical output waveform due to the asymmetry between a rise time and a fall time of the output waveform of an LD driving circuit and the deterioration of the optical output waveform such as the deterioration following a sharp decline of passing characteristics of an optical semiconductor module, and which improves the quality of the optical output waveform.

The present invention provides an optical semiconductor device as defined in claim 1.

According to the present invention, the first conductor line and the second conductor line can constitute a pair of differential lines, the first conductor line connected to one electrode of a pair of electrodes which the optical semiconductor device includes can supply an electric signal to the optical semiconductor element, the second conductor line connected to the other electrode of the pair of electrode which the optical semiconductor element includes can supply an electric signal to the optical semiconductor element, the first inductance element connected to the one electrode of the optical semiconductor element and the first conductor line can cut off the electric signal at a high frequency, and the second inductance element connected to the other electrode of the optical semiconductor element and the second conductor line can cut off the electric signal at a high frequency.

The optical semiconductor device can further include a pair of matching resistors connected to the one electrode and the other electrode of the optical semiconductor element, respectively, and introducing the electric signals to the optical semiconductor element. This can make impedance matching at the high frequency and efficiently introduce the electric signals to the optical semiconductor element.

The optical semiconductor device can further include a first bias circuit including the first inductance element and a first resistor connected in parallel to the first inductance element; and a second bias circuit including the second inductance element and a second resistor connected in parallel to the second inductance element. This can prevent a resonance caused by reactance components of the inductance elements, inductances of wire bonds, capacities of pads, and parasitic capacitances of the inductance elements, and cut off electric signals at high frequencies in wide frequency bands.

The optical semiconductor device can include, in addition, a filter that cuts off frequencies higher than at least a maximum repetition frequency of a digital signal, the filter provided between the first and the second conductor lines and the pair of matching resistors. This filter can cut off frequencies higher than at least the maximum repetition frequency of the digital signal, and remove a ringing of electric input waveforms in unnecessary frequency bands.

The filter may include a first conductor finger section and a second conductor finger section in which a plurality of conductors crossing the first and the second conductor lines are formed, respectively, to have a comb shape, the first conductor finger section and the second conductor finger sections being alternately arranged.

Such a filter can cut off frequencies higher than at least the maximum repetition frequency of the digital signal and remove the ringing of electric input waveforms in unnecessary frequency bands.

The optical semiconductor device can include a package containing therein the first and the second conductor lines; a lens that condenses a light emitted from the optical semiconductor element; and an optical fiber holding member that holds an optical fiber. Thus a semiconductor optical modulation device can be constituted.

The first and the second inductance elements can be air-cored coils. This enables making the bias circuits for cutting off high frequency electric signals in wide frequency bands small in size.

The optical semiconductor element can be a semiconductor laser diode. Thus a semiconductor optical modulation device that reduces the deterioration of the optical output waveforms of the semiconductor laser diode can be constituted.

The first and the second inductance elements may supply bias currents.

The invention will be further described by way of example with reference to the accompanying drawings, in which:-

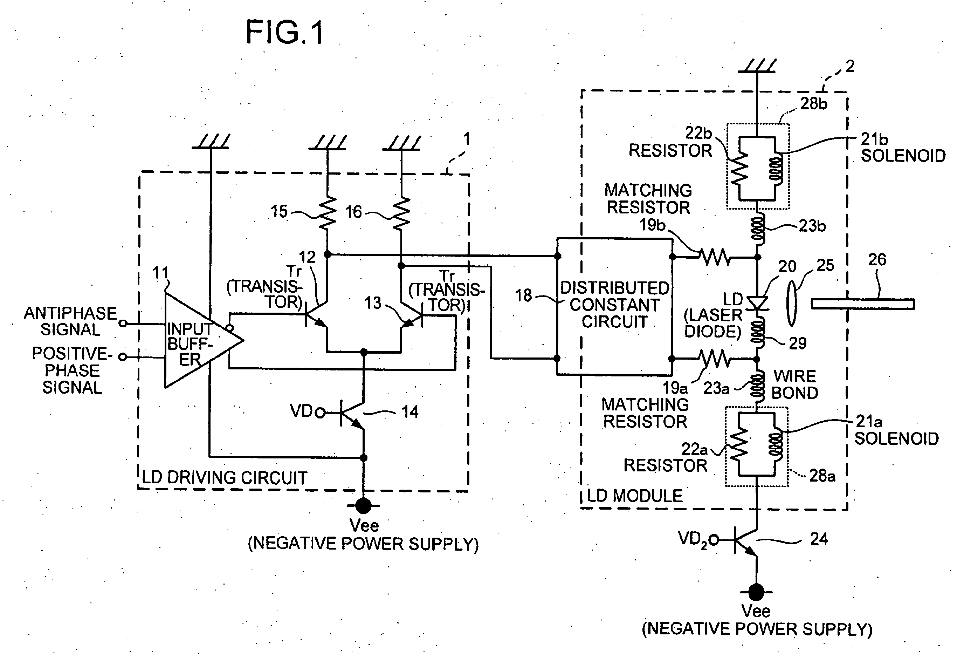

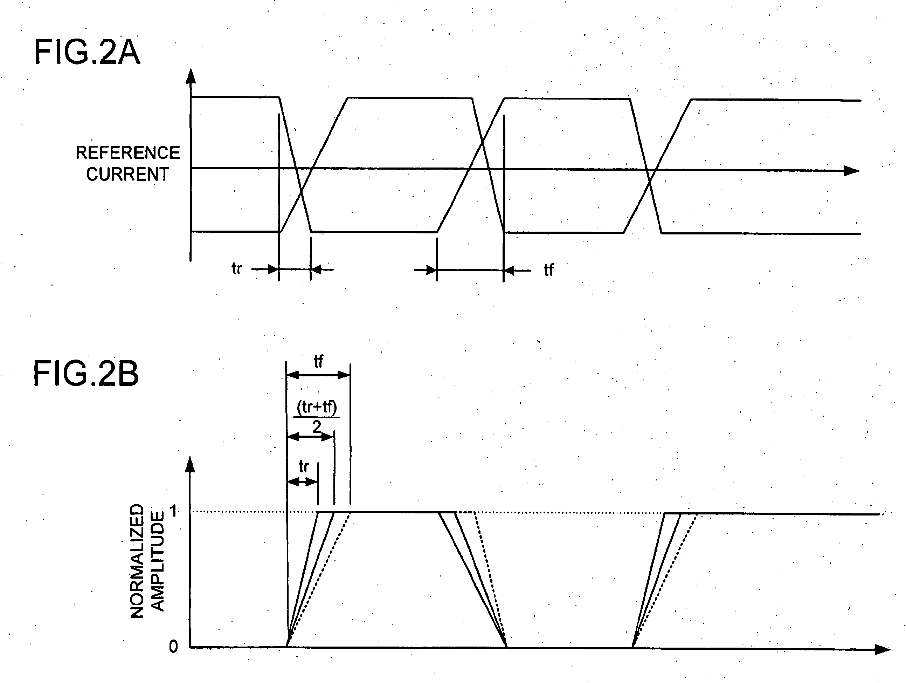

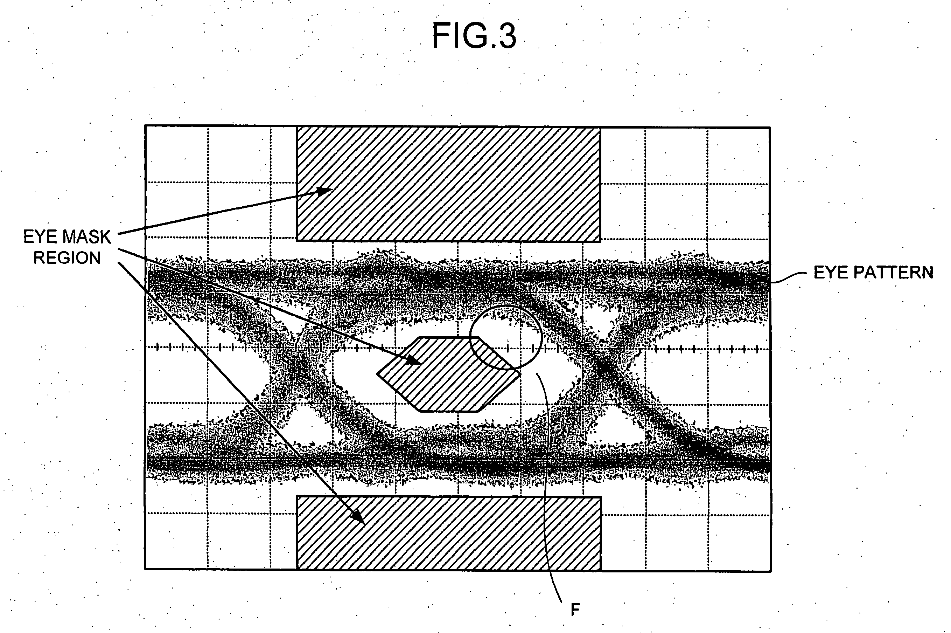

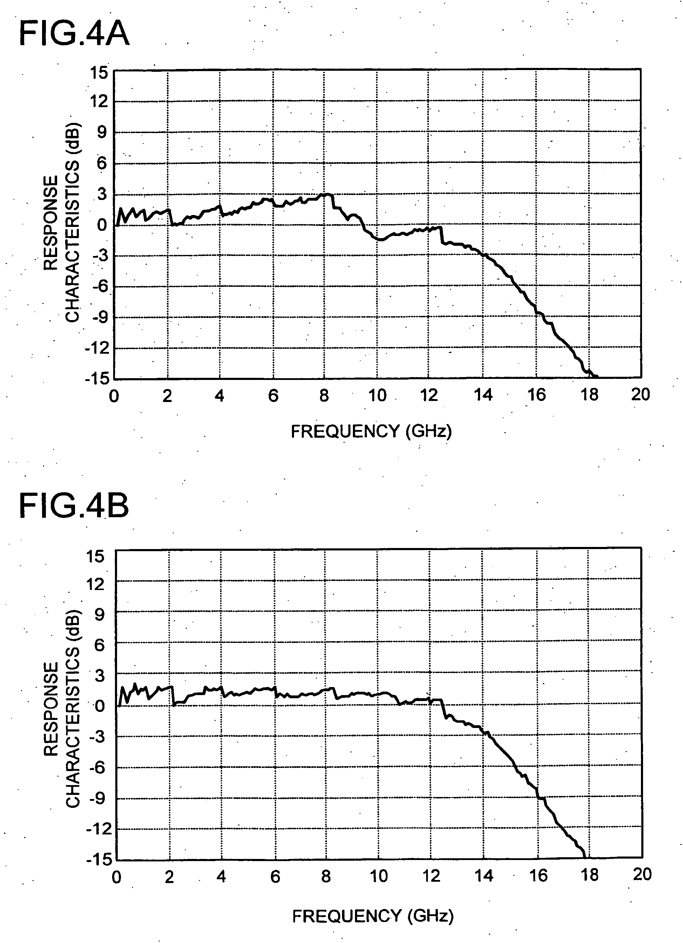

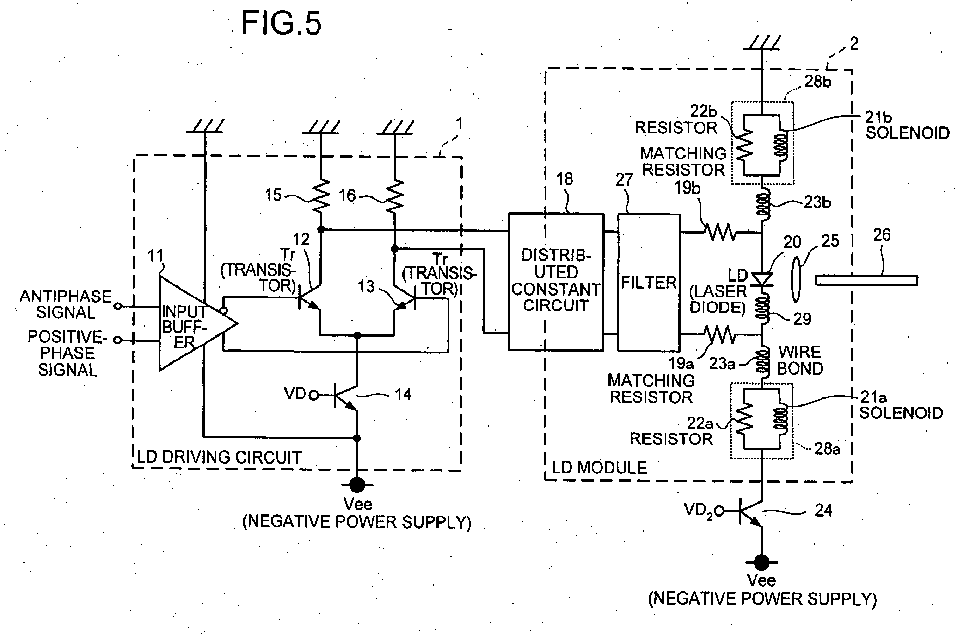

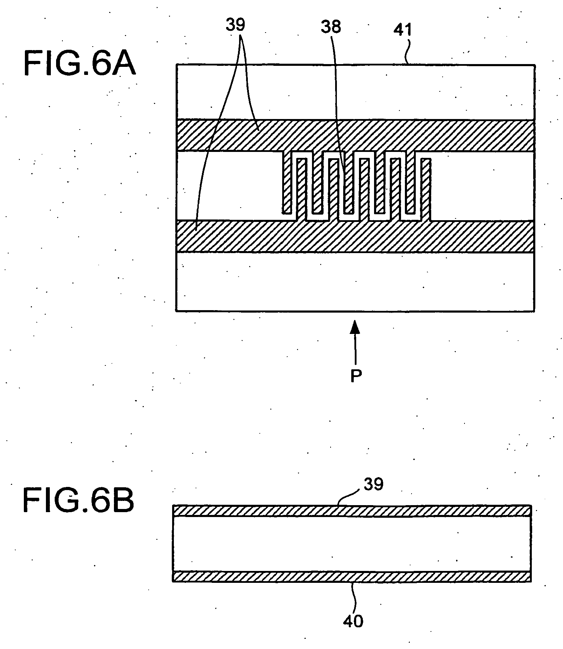

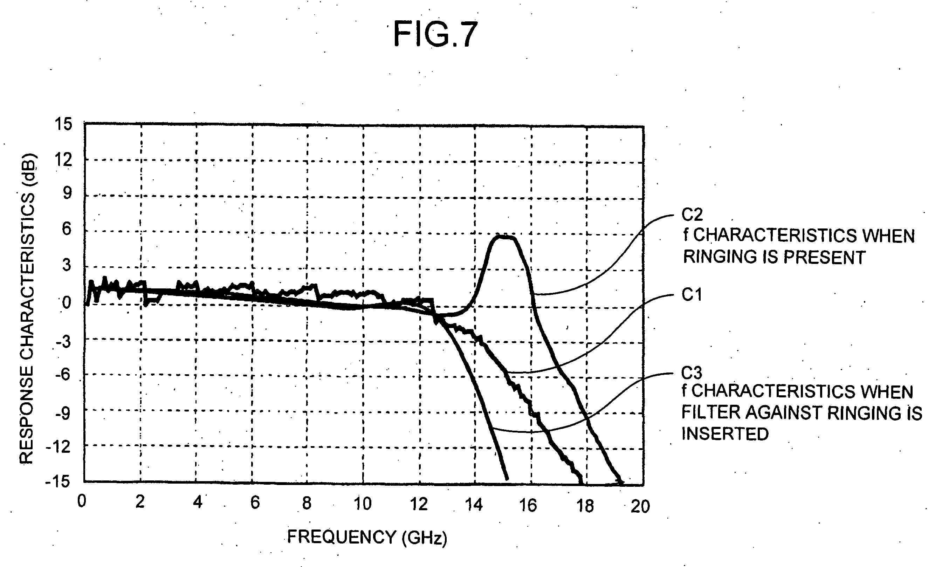

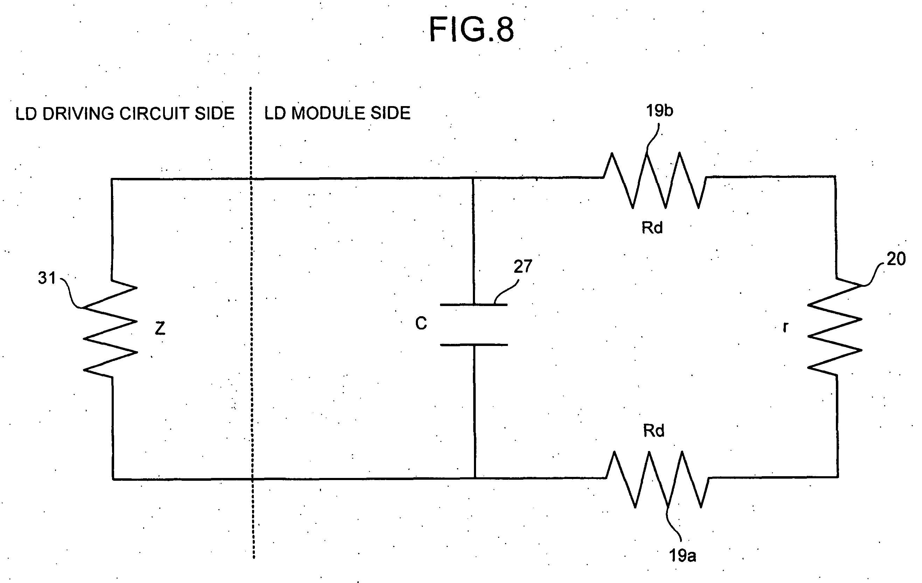

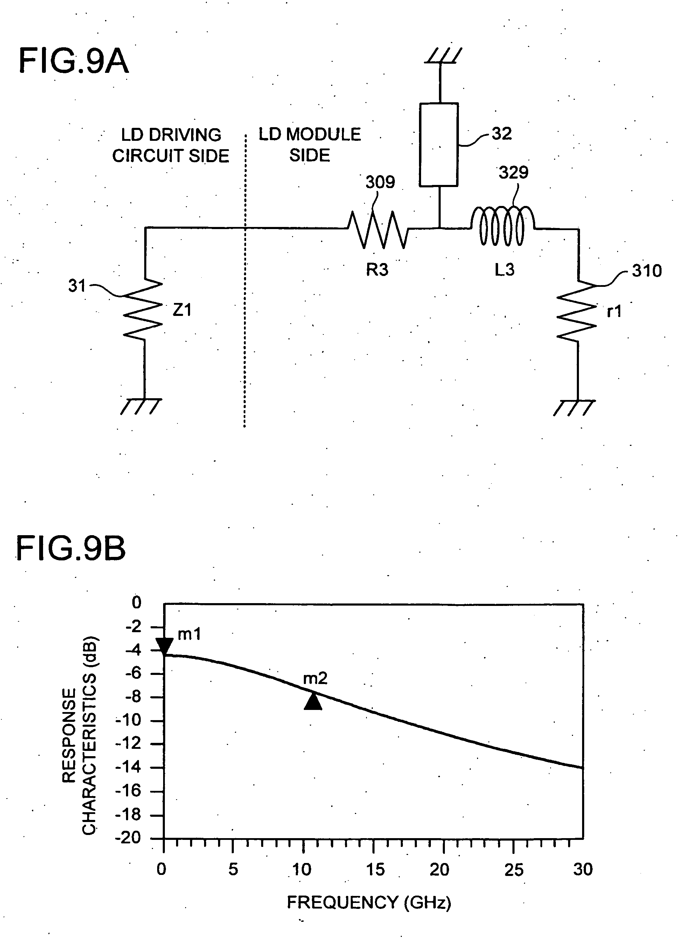

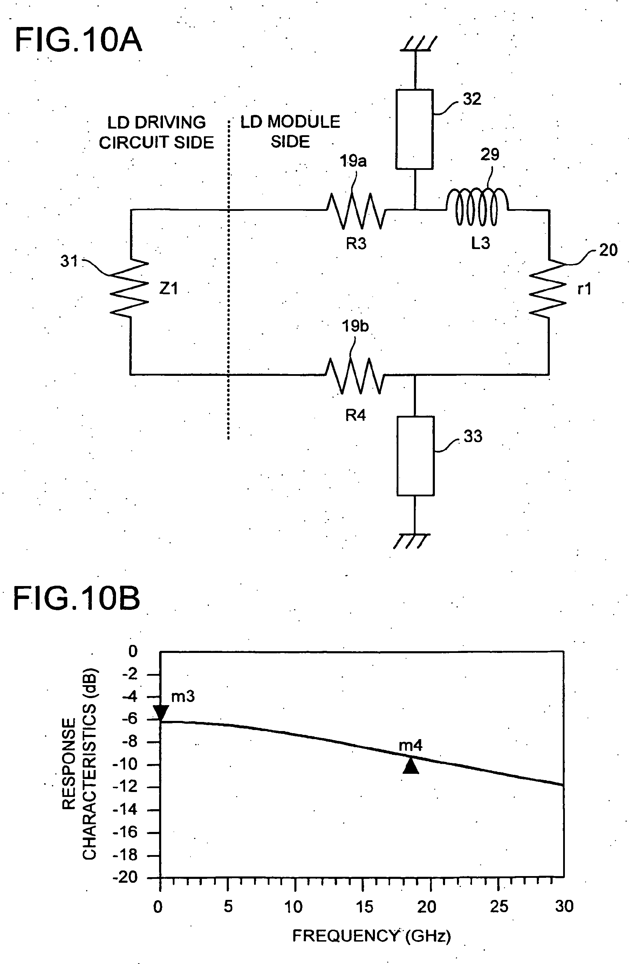

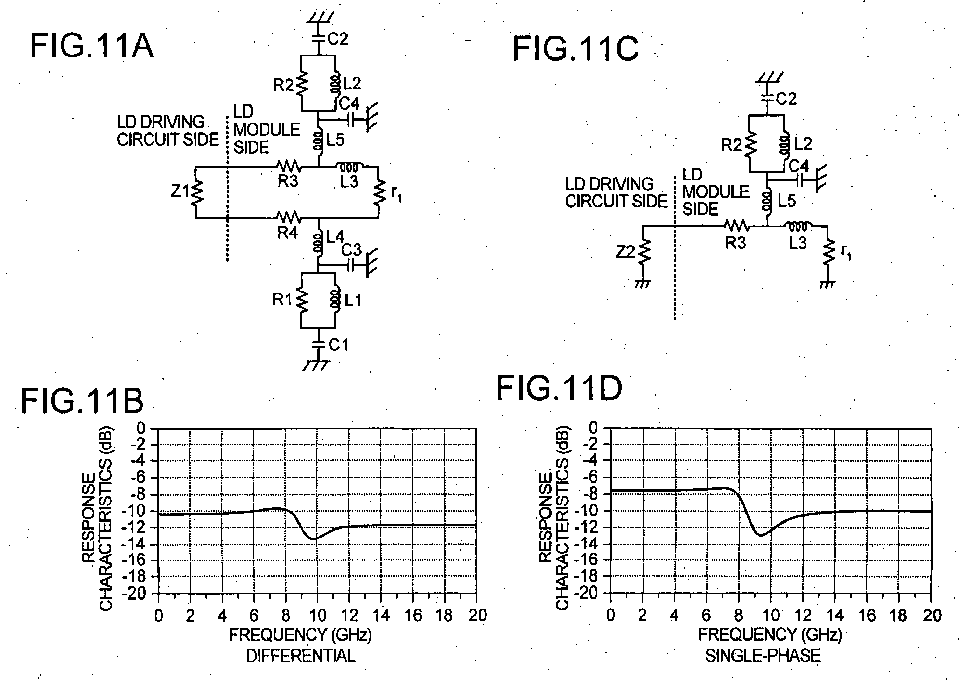

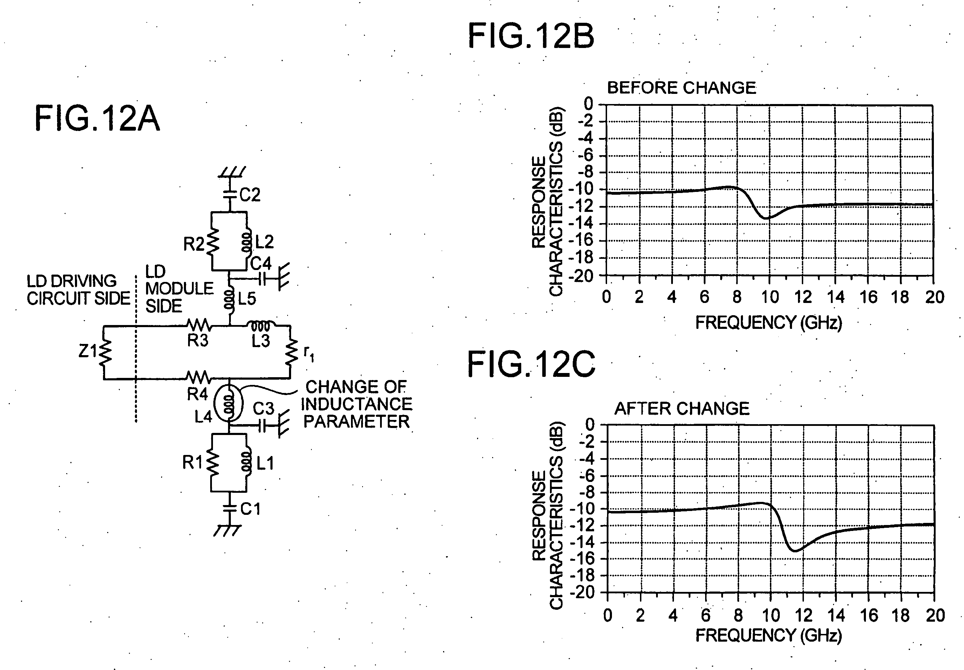

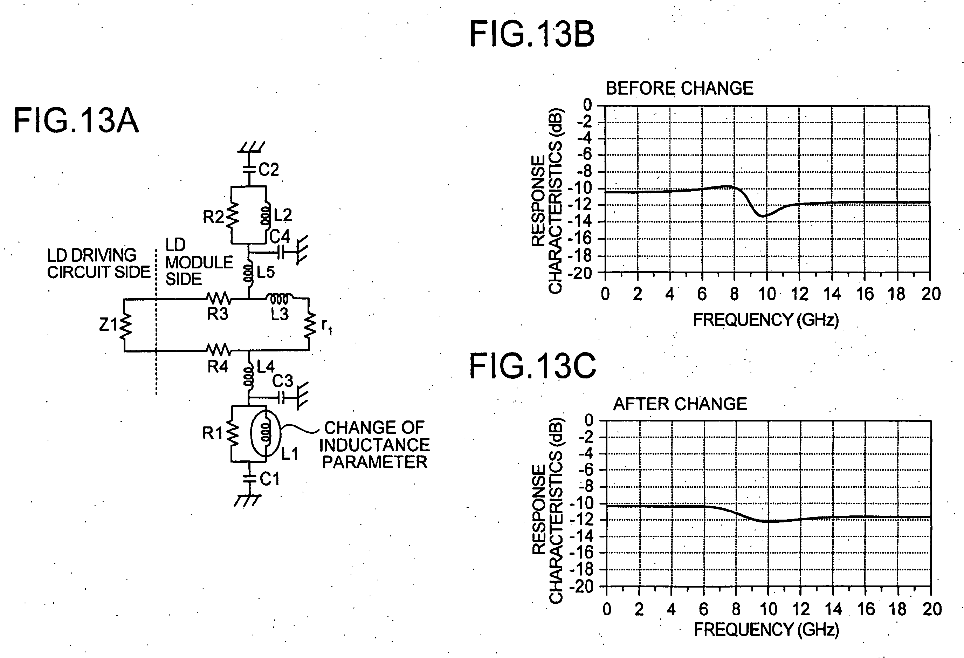

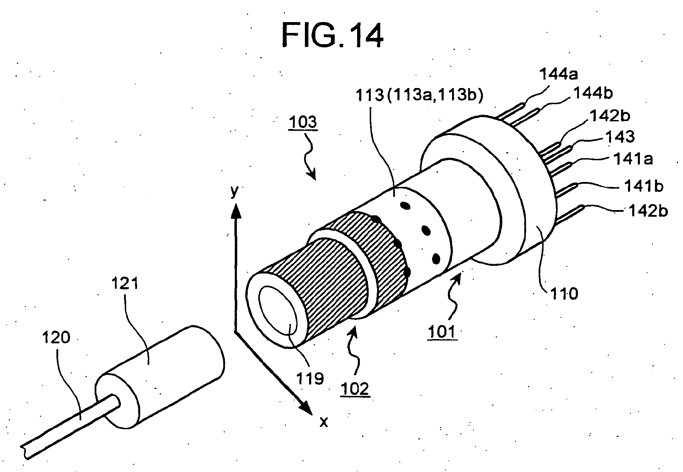

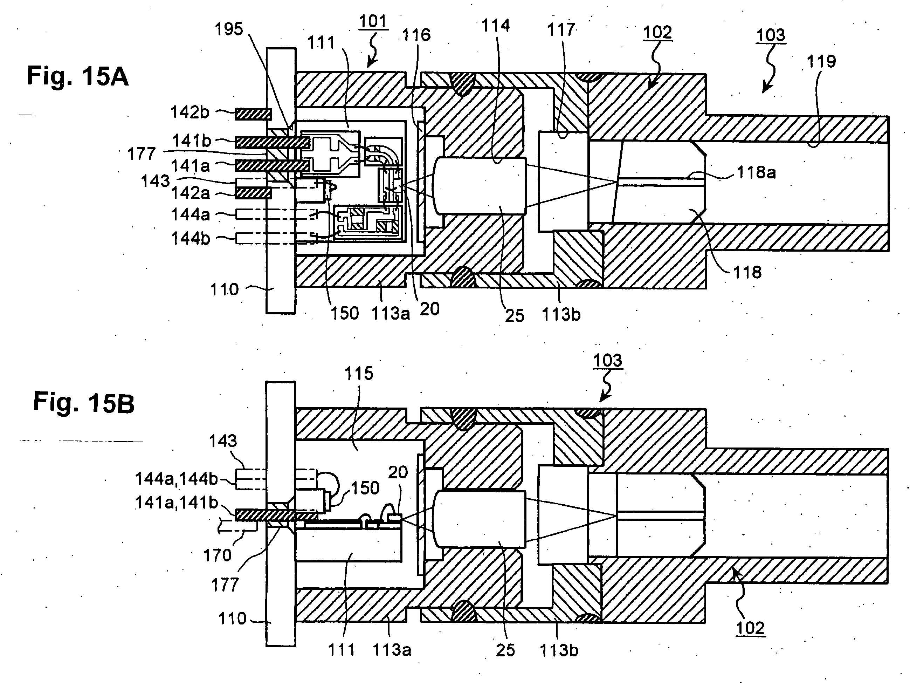

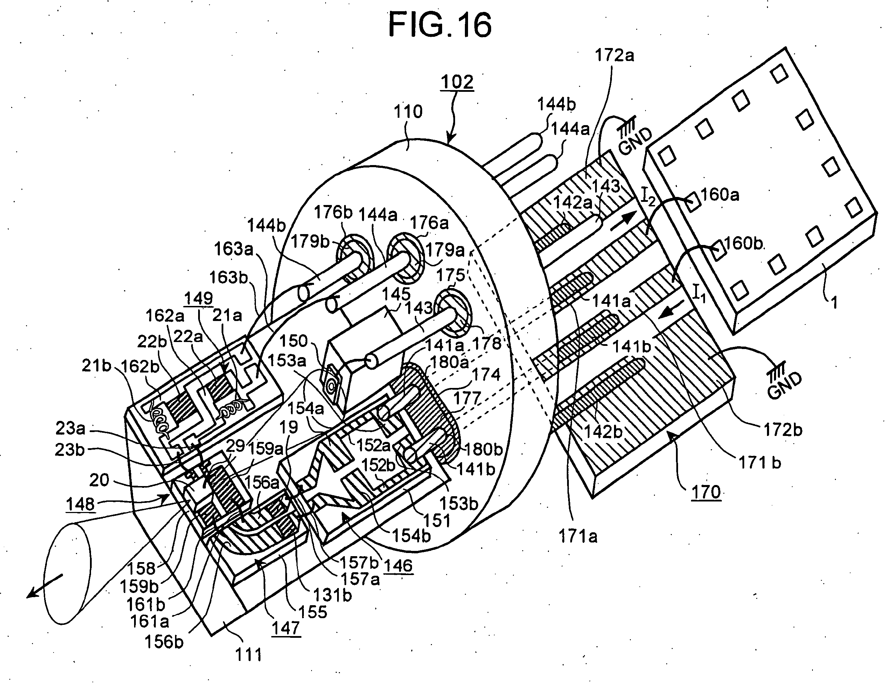

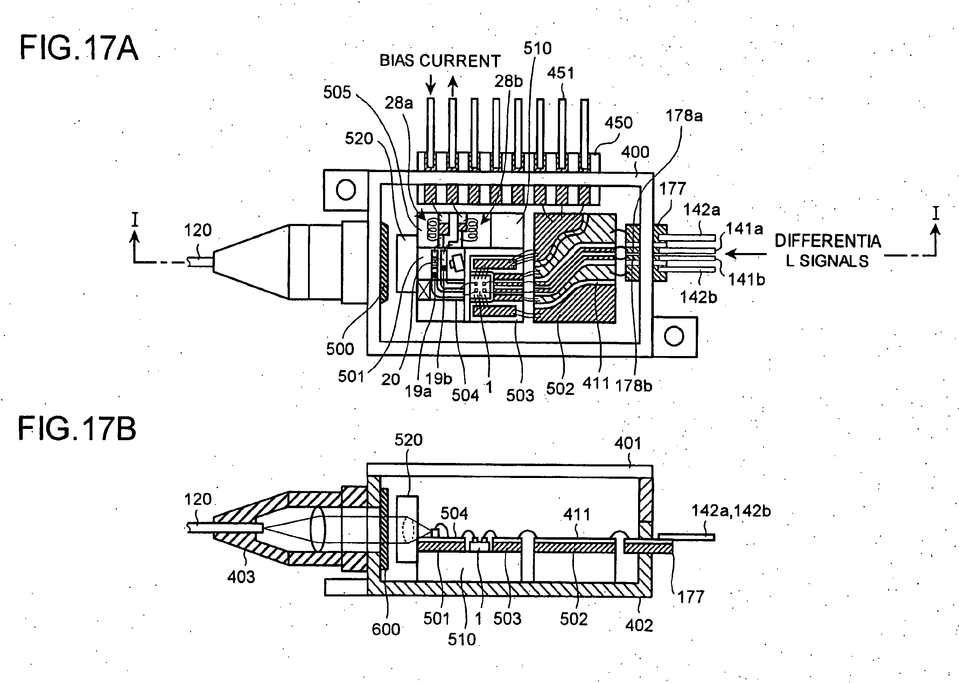

Fig. 1 is a circuit block diagram which illustrates one example of an optical semiconductor device according to the first embodiment; Fig. 2A is an explanatory view which typically illustrate rise characteristics and fall characteristics of a pair of differential transistors in an LD driving circuit; Fig. 2B is an explanatory view which illustrates a principle that the rise characteristics and the fall characteristics of the pair of differential transistors are averaged; Fig. 3 illustrates that optical signal waveforms in various patterns are photoelectrically converted to electric signals, the electric signals are passed through a band filter, and that the electric signals are overlaid; Fig. 4A is a graph which illustrates frequency response characteristics when the LD module shown in Fig. 1 is viewed from a distributed constant circuit; Fig. 4B is a graph which illustrates frequency response characteristics when respective bias circuits are set to have different impedances; Fig. 5 is a circuit block diagram which illustrates one example of the optical semiconductor device according to the second embodiment; Fig. 6A is a top view of a filter; Fig. 6B is an illustration of this filter viewed from an arrow P direction; Fig. 7 is a graph which compares frequency characteristics before and after the filter is inserted; Fig. 8 is an equivalent circuit diagram which simulates a high frequency operation of the optical semiconductor device shown in Fig. 5; Fig. 9A is a simplified equivalent circuit diagram which simulates a high frequency operation of a conventional semiconductor device shown in Fig. 18; Fig. 9B is a graph which illustrates a simulation result of the frequency response characteristics of this equivalent circuit; Fig. 10A is a simplified equivalent circuit diagram which simulates the high frequency operation of the optical semiconductor device (differential lines) according to the present invention shown in Fig. 1; Fig. 10B is a graph which illustrates a simulation result of the frequency response characteristics of this equivalent circuit; Fig. 11A is a circuit block diagram which illustrates the configuration of a bias circuit in the equivalent circuit shown in Fig. 10A in detail; Fig. 11B is a graph which illustrates the simulation result of the frequency response characteristics based on circuit conditions shown in Fig. 11A; Fig. 11C is a circuit block diagram which illustrates the configuration of the bias circuit in the equivalent circuit shown in Fig. 9A in detail; Fig. 11D is a graph which illustrates the simulation result of the frequency response characteristics based on the circuit conditions; Fig. 12A is a circuit block diagram which illustrates an identical equivalent circuit to that shown in Fig. 11A; Fig. 12B is a graph which illustrates the simulation result based on circuit conditions shown in Fig. 12A; Fig. 12C is a graph which illustrates the simulation result of frequency response characteristics in the equivalent circuit shown in Fig. 11A when an inductance L4 of a wire bond 23a (or 23b) is changed from 3 nanohenries to 1 nanohenry; Fig. 13A illustrates an identical equivalent circuit to that shown in Fig. 11A; Fig. 13B is a graph which illustrates a simulation result based on circuit conditions shown in Fig. 13A; Fig. 13C is a graph which illustrates the simulation result of the frequency response characteristics when an inductance L1 of an inductance element is changed in the equivalent circuit shown in Fig. 11A; Fig. 14 illustrates the outside configuration of the LD module which includes a can package and a receptacle; Fig. 15A is a horizontal sectional view (a view of a surface parallel to x shown in Fig. 14) of the LD module; Fig. 15B is a vertical sectional view (a view of a surface parallel to y shown in Fig. 14) of the LD module; Fig. 16 is a perspective view which illustrates the can package in a state in which a cap is detached; Fig. 17A is a top view in a state in which an upper cap is detached; Fig. 17B is a cross-sectional view taken along a line II of Fig. 17A in a state in which the upper cap is attached; Fig. 18 is a circuit diagram which illustrates one example of a conventional single-phase feed type optical semiconductor device; Fig. 19 illustrates one example of an eye pattern of electric signal waveforms output from a circuit such as an LD driving circuit shown in Fig. 18; Fig. 20 illustrates one example of an eye pattern of optical signal waveforms (optical output waveforms) output from the LD module shown in Fig. 18; and Fig. 21 is a graph which illustrates the frequency response characteristics when a signal transmission path P between the LD driving circuit and the LD module shown in Fig. 18 is constituted by a distributed constant circuit such as a micro-strip line and when the LD module is viewed from this distributed constant circuit.

BEST MODE FOR CARRYING OUT THE INVENTION

Exemplary embodiments of the optical semiconductor device according to the present invention is described in detail below with reference to the accompanying drawings.

FIRST EMBODIMENT

Fig. 1 is a circuit block diagram which illustrates one example of an optical semiconductor device according to the first embodiment. In Fig. 1, an LD driving circuit 1 includes an input buffer 11 which has a differential input configuration, a pair of differential transistors 12 and 13 which have differential configuration and which output an antiphase signal and a positive phase signal, respectively, a transistor 14 which performs a constant-current operation, and resistors 15 and 16 which are loads of collectors of the differential transistors 12 and 13, respectively, and which make impedance matching.

The input buffer 11 shapes waveforms of input antiphase signal and positive phase signal, and generates the adjusted antiphase signal and positive phase signal to be input to bases of the differential transistors 12 and 13.

The paired differential transistors 12 and 13 that have the differential configuration and the transistor 14 constitute a differential amplifier. Collector sides of the differential transistors 12 and 13 are connected to one side of the resistors 15 and that of the resistor 16, respectively. The other sides of the resistors 15 and 16 are connected to ground terminals, respectively. Emitters of the differential transistors 12 and 13 are connected to the transistor 14 which performs the constant-current operation. An antiphase signal output terminal of the input buffer 11 is connected to the base of the differential transistor 12, and a positive phase signal output terminal of the input buffer 11 is connected to the base of the differential transistor 13. An emitter side of the transistor 14 and a voltage input terminal of the input buffer 11 are both connected to a negative power supply (Vee).

Collector-side output terminals of the differential transistors 12 and 13 are connected to a pair of electrodes (an anode and a cathode) of an LD 20 through a distributed constant circuit 18, which includes micro-strip lines or grounded coplanar lines, and matching resistors 19a and 19b, respectively.

The differential transistors 12 and 13 may be replaced by field-effect transistors (hereinafter, "FETs"). If the FETs are employed, the anode and cathode of the LD 20 are connected to drains of the FETs, respectively.

On the LD module 2 side, the differential transistors 12 and 13 are connected to the LD 20 having a high frequency impedance of about 5 ohms through the distributed constant circuit 18 and the matching resistors 19a and 19b for impedance matching each having an impedance of about 20 ohms. The anode side of the LD 20 is bonded to a conductor line electrically connected to the matching resistor 19b by soldering or the like, and the cathode side of the LD 20 is connected to a conductor line electrically connected to the matching resistor 19a. The distributed constant circuit 18 is constituted so that the output terminals of the differential transistors 13 and 12 of differential type in the LD driving circuit 1 are connected to the matching resistors 19a and 19b by differential lines or wire bonds, respectively. The differential lines are obtained by arranging two conductor lines to be proximate to each other, and signal transmission is performed so that one of input signals to the two conductor lines is a positive-phase signal and the other input signal is an antiphase signal. It is thereby possible to improve electrical coupling between the two conductor lines and reduce leakage loss of an electric field.

In, for example, the conventional single-phase driving type optical semiconductor device, since a high current that drives the LD is fed back to the LD driving circuit through a ground, a ground potential changes. This ground potential change often adversely affects an optical reception electronic circuit arranged proximate to the device and detecting a feeble current. In this embodiment, by contrast, the optical semiconductor device performs a push-pull operation with respect to the LD using the differential lines. Therefore, the optical semiconductor device in this embodiment has advantages in that the high current carries across the differential lines, the ground potential has less change, and peripheral circuits are less influenced.

The differential lines include differential type micro-strip lines (micro-strip differential lines) obtained by arranging two signal transmission lines proximate to each other, differential type grounded coplanar lines (grounded coplanar differential lines), differential pins (or leads) obtained by arranging two conductor pins proximate to each other, or the like.

A solenoid 21a having a high impedance with respect to a high frequency and a resistor 22a connected in parallel to this solenoid 21a and reducing a Q value for preventing a resonance constitute a first bias circuit 28a. A solenoid 21b having a high impedance with respect to the high frequency and a resistor 22b connected in parallel to this solenoid 21b and reducing the Q value for preventing the resonance constitute a second bias circuit 28b. Air-cored coils which cause bias currents (direct currents) to pass through, and which suppress modulated signals (electric signals at several hundred kilohertz to several tens of gigahertz) output from the LD driving circuit 1 from leaking from the first and the second bias circuits 28a and 28b, i.e., which cut off high frequency signals are used for the solenoids 21a and 21b, respectively. The solenoid 21a in the first bias circuit 28a and the solenoid 21b in the second bias circuit 28b are connected to the conductor lines, one ends of which are electrically connected to the anode and cathode of the LD 20, through the wire bonds 23a and 23b, respectively. Thus, the bias circuit 28a is connected to the conductor line electrically connected to the matching resistor 19a through the wire bond 23a, and connected to the cathode of the LD 20 through a wire bond 29. The bias circuit 28b is connected to the conductor line electrically connected to the matching resistor 19b through the wire bond 23b, and connected to the soldered conductor line (pad) on the anode of the LD 20.

The anode side of the LD 20 is connected to a ground terminal through the parallel circuit in the second bias circuit 28b. The cathode side of the LD 20 is connected to a constant current source 24 through the parallel circuit in the second bias circuit 28a. The constant current source 24 includes a transistor and an emitter side of the constant current source 24 is connected to a negative power supply (Vee). This negative power supply is set equal in voltage to the negative power supply (Vee) to which the transistor 14 in the LD driving circuit 1 is connected. Alternatively, they may be set at different voltages.

The bias circuits 28a and 28b, together with the wire bonds 23a and 23b and the like, act as ungrounded open terminals for high frequencies.

With the driving configuration of this LD 20, direct current (hereinafter, "DC") bias currents are supplied to the anode and cathode of the LD 20 through the paired first and second bias circuits 28a and 28b, respectively, and high frequency modulation currents are input to the anode and cathode of the LD 20 in a differential manner by the paired differential transistors 12 and 13 of the differential type, respectively.

Namely, if a state of the differential transistor 12 in the LD driving circuit 1 changes from ON to OFF (a state of the differential transistor 13 changes from OFF to ON), the modulation current flows in the LD 20 and a state of an laser light output from the LD 20 changes from OFF to ON. If the state of the differential transistor 13 changes from ON to OFF (the state of the differential transistor 12 changes from OFF to ON), the modulation current flowing in the LD 20 decreases and the state of a laser light output of the LD 20 changes from ON to OFF

Accordingly, the modulated electrical signals output from the differential transistors 12 and 13 constituted to be differential from each other in the LD driving circuit 1 are transmitted to the LD 20 through the distributed constant circuit 18 and the like, and converted to optical modulation signal in the LD 20. The modulated optical signals generated from the LD 20 are condensed on an optical fiber 26 by a condenser lens 25 and the condensed, modulated optical signal is output through this optical fiber 26.

Fig. 2A is an explanatory view which typically illustrates rising and fall characteristics of the paired differential transistors 12 and 13 in the LD driving circuit 1. Fig. 2B is an explanatory view which illustrates a principle that the rising and fall characteristics of the paired differential transistors 12 and 13 are averaged.

As shown in Fig. 2B, if a rise time of the differential transistor 12 or 13 (it is assumed that the transistors 12 and 13 are equivalent in characteristics) is tr and a fall time thereof is tf, tr and tf satisfies a relationship of tr < tf. This is already explained above.

Further, as explained, the positive-phase signal and the antiphase signal are passed through the distributed constant circuit 18, and one is connected to the cathode of the LD 20 through the matching resistor 19a and the other is connected to the anode of the LD 20 through the matching resistor 19b. By so connecting, when the differential transistor 12 rises, the differential transistor 13 simultaneously rises and when the differential transistor 12 falls, the differential transistor 13 simultaneously falls. Therefore, if the operation is viewed from the LD 20, the LD 20 is push-pull driven by the paired differential transistors 12 and 13.

As for the circuits in the conventional optical semiconductor device shown in Fig. 18, in the LD driving circuit 200, the paired transistors perform a differential operation. If the operation is viewed from the LD 310, the operation is simply such that when the differential transistor 203 rises, a current flows in the LD 310, and that when the differential transistor 203 falls, no current flows in the LD 310. Namely, if the operation is viewed from the LD 310 (or the distributed constant circuit that connects the LD driving circuit 200 to the LD 310), the LD 310 is not push-pull driven.

The circuits in the optical semiconductor device according to the present invention shown in Fig. 1 perform such a push-pull operation. Therefore, the distributed constant circuit 18 serves as differential lines, performs current push and pull for the LD 20 simultaneously. If the operation is viewed from the LD 20, the circuits operate for an average time ((tr + tf) / 2) between the rise time (tr) of the differential transistor 12 and the fall time (tf) of the differential transistor 13. As a result, as shown in Fig. 2B, the paired transistors 12 and 13 exhibit symmetric rise characteristics that the rise time and the fall time are averaged.

Fig. 3 illustrates that optical signal waveforms in various patterns are photoelectrically converted to electric signals and that the electric signals are passed through a band filter and overlaid. In Fig. 3, an upper part is a mark side (light emission) and the horizontal axis indicates time. As can be seen from Fig. 3, waveform asymmetry is improved, there are enough margins to the eye mask prescriptions, and good transmission characteristics can be obtained, as compared with the eye pattern shown in Fig. 20.

Near an upper right part (a rising part indicated by F in Fig. 3) of a central portion of the eye pattern, in particular, there is an enough margin to the eye mask prescription, so that a margin to a waveform deterioration following a lowering in the relaxation oscillation frequency of the LD 20 due to an increase of a using temperature.

Further, as regards the rise characteristics of the LD driving circuit having the relatively long rise time and fall time shown in Fig. 19, the LD driving circuit 200 is adjusted to have peaking characteristics. If so, a slight ringing at a frequency around 15 gigahertz higher than a signal band often occurs and is superposed on the electric waveform shown in Fig. 19.

This ringing can lift up the rising waveform of the optical output waveform, a right shoulder (lower right part) of the eye pattern has margins to the eye mask, and the quality of the optical output waveforms can be enhanced. If a fundamental wave of a digital signal at 10 Gb/s (minimum pulse) is at, for example, 5 gigahertz, the peaking of the LD driving circuit 200 is adjusted so that the ringing occurs at a harmonics three times higher than 5 gigahertz, i.e., 15 gigahertz, whereby high-quality optical output waveforms can be obtained.

Japanese Patent Application Laid-Open Publication No. 11-233876 discloses an example of the laser module that transmits data without jitters by holding a balance between differential load impedances. However, the laser module does not perform a push-pull operation if the operation is viewed from the LD. Therefore, the invention disclosed by the publication differs from the present invention.

Japanese Patent Application Laid-Open Publication No. 5-327617 discloses that only the fall time is improved by reducing the input impedance of the LD which impedance is viewed from the driving circuit. Therefore, the invention of the publication entirely differs in principle from the present invention.

Fig. 4A is a graph which illustrates frequency response characteristics when the LD module 2 shown in Fig. 1 is viewed from the distributed constant circuit 18. As explained, the bias circuit 23a, in which the solenoid 21 a and the resistor 22a are arranged in parallel, is connected to the cathode side of the LD 20 in the LD module 2 shown in Fig. 1, and the bias circuit 23b, in which the solenoid 21 b and the resistor 22b are arranged in parallel, is connected to the anode side of the LD 20 in the LD module 2. Therefore, the respective bias circuits 28a and 28b generate a resonance due to the capacitance components of the pad sections provided on the ceramic substrate or the like, similarly to the example of the conventional LD module 300. However, if the LD module 2 is viewed as an equivalent circuit from the distributed constant circuit 18 side, the two bias circuits appear as if they are connected in series. Therefore, an amplitude of the resonance can be reduced, and the sharp decline at the frequency around 10 gigahertz as shown in Fig. 21 is prevented. In the example shown in Fig. 4A, the graph which illustrates the frequency response characteristics when the impedances of the resistors 22a and 22b are set equal is shown.

Fig. 4B is a graph which illustrates the frequency response characteristics when the bias circuits 28a and 28b are set to have different impedances. As shown in Fig. 4B, waviness is improved as compared with the graph of Fig. 4A. Specific examples of inductances and resistors will be explained later in the third and the fourth embodiments.

Japanese Patent Application Laid-Open Publication No. 5-37083 discloses a problem that an inductance Ls of a bonding wire for connecting a bias circuit to a semiconductor laser and a parasitic capacitance Cs1 of a ceramic block of an airtight package provided for connecting the bias circuit to an external circuit cause the deterioration of small signal frequency characteristics. According to the publication, with a view of reducing the influence of this parasitic capacitance Cs1, metallization applied on a lower surface of a bias line arranged on the ceramic block of the airtight package is removed and the parasitic capacitance in the circuit is thereby removed. A lower surface of the ceramic block is a part other than the lower surface of the bias line and metallization thereof is not removed.

Nevertheless, the invention disclosed by Japanese Patent Application Laid-Open Publication No. 5-37083 employs the single-phase line to supply a modulated signal to the semiconductor laser. The publication does not disclose an example of the circuit in which differential lines are employed, an example in which two bias circuits are employed, and an example in which impedances of the two bias circuits are set differently. In addition, the invention of the publication differs in circuit configuration from the first embodiment of the present invention in which the two bias circuits connected to the differential lines are arranged.

Moreover, the invention of Japanese Patent Application Laid-Open Publication No. 5-37083 moves a damping frequency of 3 decibels of the passing characteristics caused by the resonance from 2.5 gigahertz to 2.9 gigahertz on the frequency axis. The invention of the publication thus totally differs from the first embodiment of the present invention in which the amplitude of the resonance is changed.

As can be seen, according to the first embodiment, the optical semiconductor element to which the differential lines are connected is driven by the push-pull operation. Therefore, the first embodiment exhibits advantages in that the asymmetry of the electric driving waveform is improved, the quality of the optical output waveform is improved, and good transmission characteristics can be thereby obtained.

Further, the bias circuits are arranged on the both sides of the optical semiconductor element to which the differential lines are connected. Therefore, if the optical semiconductor element is assumed as the equivalent circuit, the two bias circuits appear to be connected in series to the optical semiconductor element. Hence, the amplitude of the resonance can be reduced, the sharp decline (ripple) of the passing characteristics followed by the arrangement of the bias circuits can be improved, the quality of the optical output waveform can be improved, and the good transmission characteristics can be thereby obtained.

In the first embodiment, the optical semiconductor device in which the LD is directly modulated has been shown. The first embodiment is also applicable to an optical semiconductor device separately including a light source that outputs a light of a certain intensity, such as an optical semiconductor device using a field absorption type semiconductor modulation element. Such an optical semiconductor device has the same functions and advantages as those of the first embodiment.

In the first embodiment, each solenoid is employed as an element that prevents a serial resonance. However, any other element can be used as long as the element has an inductance component (the element is an inductance element). For example, a chip inductor including a pattern wiring on the ceramic substrate, or a wire having a diameter of 0.01 to 0.5 millimeter and a length of about 10 millimeters may be used.

As explained so far, according to the optical semiconductor device in the first embodiment, the optical semiconductor element to which the differential lines are connected is driven by the push-pull operation. Therefore, the optical semiconductor device has advantages in that the asymmetry of the waveform can be improved, the quality of the optical output waveform is improved, and the good transmission characteristics can be thereby obtained.

Further, according to the optical semiconductor device in the first embodiment, the bias circuits are arranged on the both sides of the optical semiconductor element to which the differential lines are connected. Therefore, the ripple of the passing characteristics followed by the arrangement of the bias circuits can be improved, the quality of the optical output waveform can be improved, and the good transmission characteristics can be thereby obtained.

SECOND EMBODIMENT

Fig. 5 is a circuit block diagram which illustrates one example of the optical semiconductor device in the second embodiment. In Fig. 5, the LD driving circuit 1 includes the input buffer 11 which has differential input configuration, the paired differential transistors 12 and 13 which have differential configuration to output an antiphase signal and a positive phase signal, respectively, the transistor 14 which performs a constant-current operation, and the resistors 15 and 16 which are resistors against the loads of collectors of the differential transistors 12 and 13, respectively, and which make impedance matching.

The input buffer 11 shapes waveforms of input antiphase signal and positive phase signal, and generates the adjusted antiphase signal and positive phase signal to be input to bases of the differential transistors 12 and 13.

The paired differential transistors 12 and 13 that have the differential configuration and the transistor 14 constitute a differential amplifier. Collector sides of the differential transistors 12 and 13 are connected to one side of the resistor 15 and that of the resistor 16, respectively. The other sides of the resistors 15 and 16 are connected to ground terminals, respectively. Emitters of the differential transistors 12 and 13 are connected to the transistor 14 which performs the constant-current operation. The antiphase signal output terminal of the input buffer 11 is connected to the base of the differential transistor 12, and the positive phase signal output terminal of the input buffer 11 is connected to the base of the differential transistor 13. An emitter side of the transistor 14 and a voltage input terminal of the input buffer 11 are both connected to the negative power supply (Vee).

The (collector-side) output terminals of the differential transistors 12 and 13 are connected to the anode and the cathode of the LD 20 through the distributed constant circuit 18, which includes micro-strip lines or grounded coplanar lines, and the matching resistors 19a and 19b, respectively.

The differential transistors 12 and 13 may be replaced by the FETs. If the FETs are employed, the anode and cathode of the LD 20 are connected to drains of the FETs, respectively.

The LD module 2 sides of the differential transistors 12 and 13 are connected to the anode side of LD 20 having a high frequency impedance of about 5 ohms by soldering and to the cathode side thereof by the wire bond 29 through the distributed constant circuit 18, a filter 27, and the matching resistors 19a and 19b for impedance matching each having an impedance of about 20 ohms. The differential transistors 12 and 13 are connected to the first bias circuit 28a which includes the solenoid 21a having a high impedance with respect to a high frequency and the resistor 22a connected in parallel to this solenoid 21 a and reducing a Q value for preventing a resonance, and to the second bias circuit 28b which includes the solenoid 21 b having a high impedance with respect to a high frequency and the resistor 22b connected in parallel to this solenoid 21 b and reducing a Q value for preventing a resonance through wire bonds 23a and 23b, respectively.

The anode side of the LD 20 is connected to the ground terminal through the wire bond 23b and the parallel circuit in the second bias circuit 28b. The cathode side of the LD 20 is connected to the bias constant-current source 24 through the wire bonds 29 and 23a and the parallel circuit in the second bias circuit 28a. The constant-current source 24 includes a transistor and an emitter side of the constant current source 24 is connected to the negative voltage source (Vee). This negative voltage source is equal in voltage to the negative voltage source (Vee) to which the transistor 14 in the LD driving circuit 1 is connected. Alternatively, these negative voltage sources may be set at different voltages.

Similarly to the first embodiment, DC bias currents are supplied to the anode and cathode of the LD 20 through the paired bias circuits 28a and 28b, and high frequency modulated signals are input to the anode and cathode of the LD 20 by the paired differential type differential transistors 12 and 13 in a differential manner.

If a peaking is applied to the LD driving circuit 1 by changing a circuit constant, not shown in Fig. 5, in order to improve the rise characteristics of the differential transistors 12 and 13 in the LD driving circuit 1, a ringing at cycles of about 15 gigahertz occurs. The filter 27 shown in Fig. 5 is a lowpass filter for removing this ringing.

In a 1.31 micrometer wavelength band in which optical fiber dispersion is less influential, waveform change after optical fiber transmission is small and this ringing waveform is attenuated by a filter of a receiver. Therefore, an optical output waveform having larger margins to the eye mask can be obtained. This ringing can be, therefore, actively utilized for the improvement of the signal waveform after the signal is passed through the filter of the receiver. However, in a 1.55 micrometer wavelength band in which the optical fiber dispersion influence is large, if this ringing waveform is present, a wavelength chirp resulting from the optical semiconductor light emitting element grows and the chirp may possibly adversely affect the waveform after the signal is transmitted over the optical fiber. For this reason, the ringing is removed by the filter 27.

Fig. 6A is a top view of the filter 27, and Fig. 6B is an illustration of this filter 27 viewed from an arrow P direction. In Fig. 6A and Fig. 6B, the filter 27 includes a pair of micro-strip differential lines 39 on an upper surface of a ceramic substrate 41 and a ground conductor 40 on a lower surface thereof. In addition, a comb-like strip conductor electrode 38 is formed alternately from the paired micro-strip conductor lines 39 in an inward direction orthogonal to the micro-strip conductor lines 39.

Fig. 7 is a graph which compares frequency response characteristics before and after insertion of the filter 27. In Fig. 7, C1 indicates the curve of Fig. 4B and indicates a waveform in which the waviness of the response characteristics is improved by setting the impedances of the bias circuits 28a and 28b shown in Fig. 5 asymmetric to each other. C2 is a waveform indicating the response characteristics if the peaking is applied to the LD driving circuit 1 shown in Fig. 5 by changing the circuit constant, not shown when a ringing at cycles of about 15 gigahertz occurs. C3 is a waveform which indicates the response characteristics when the ringing around 15 gigahertz is cut off by the filter 27. Fig. 7 shows that flat and good frequency response characteristics are obtained up to the frequency exceeding 12 gigahertz.

Japanese Patent Application Laid-Open Publication No. 7-38185 discloses, in Figs. 6A and 6B, a circuit in which serial circuits including a capacitance and a resistor are inserted in parallel to an LD element and which thereby prevents the ringing of rise characteristics. An object of this circuit is, however, to remove an overshoot which occurs because no bias current is applied and a relaxation oscillation, which object differs from the object of the present invention. Further, the circuit of the publication differs from the present invention in that the circuit is a single-phase feed type and also differs in circuit configuration.

Japanese Patent Application Laid-Open Publication No. 7-46194 discloses, in Fig. 1 and Figs. 2A and 2B, a circuit which changes a matching state by connecting, in parallel, serial circuits including an inductance and a resistor to an LD element between a matching resistor and an LD driving circuit, to thereby prevent a ringing. However, the invention differs from the present invention in object and circuit configuration and also differs in that the circuit is of a single-phase feed type.

Fig. 8 is a simplified equivalent circuit diagram which simulates a high frequency operation of the optical semiconductor device shown in Fig. 5. Reference symbol 31 denotes an output impedance of the LD driving circuit. On an LD module side, reference symbols correspond to those that denote the respective element of the LD module shown in Fig. 5, i.e., reference symbols 19a and 19b denote the matching resistors, 20 denotes an LD, and 27 denotes the filter.

If it is assumed herein that resistances of the matching resistors 19a and 19b are Rd, an internal resistance of the LD 20 is r, a capacitance of the filter 27 is C, and the output impedance of the LD driving circuit is Z, then an approximate equation of a cutoff frequency fc of this equivalent circuit is expressed as follows:

$$fc = \frac{1}{2\pi RC}, \text{ where } R = \frac{(2Rd + r)Z}{2Rd + r + Z}$$

For example, if the impedance Z of the LD driving circuit side is 100 ohms, the internal resistance r of the LD 20 is 8 ohms, and the resistances Rd of the matching resistors are 45 ohms, and the capacitance C of the filter 27 is 0.16 picofarad, then the cutoff frequency fc is approximated to about 10 gigahertz. Since the actual circuit constant is complicated, the cutoff frequency cannot be simply obtained. However, if the capacitance is set based on this cutoff frequency fc, a desired filter effect can be obtained.

As explained, according to the second embodiment, the optical semiconductor device includes the first and the second conductor finger sections in which a plurality of conductors crossing the first and the second conductor lines, respectively, are formed into a comb, the filter in which the first conductor finger section and the second conductor finger section are alternately arranged cuts off frequencies at least higher than a maximum repetition frequency, and the filter removes or reduces the unnecessary ringing of the LD output which occurs when the peaking is applied to the LD driving circuit. Therefore, it is possible to improve a signal-to-noise ratio of the optical output signal, to improve the quality of the optical output waveform, accordingly, and obtain the good transmission characteristics.

In the second embodiment, the example of using the comb-like filter as the element that prevents the ringing is shown. Any other element can be used as long as the element has a capacitance component and the element can be constituted by an ordinary conductor pattern or the like.

In the second embodiment, the optical semiconductor device in which the LD is directly modulated is illustrated. The second embodiment is also applicable to an optical semiconductor device separately including a light source that outputs a light of a certain intensity, such as an optical semiconductor device using a field absorption type semiconductor modulation element. Such an optical semiconductor device has the same functions and advantages as those of the second embodiment.

THIRD EMBODIMENT

In the first embodiment, the advantages of using the differential lines have been explained while centering around the advantage of compensating the asymmetry of the rise/fall characteristics of the LD driving circuit and improving the optical output waveform. By employing the differential lines, there is an advantage in that frequency characteristics can be improved besides the advantage of compensating the asymmetry of the rise and fall characteristics. In this embodiment, the advantage of improving the frequency characteristics will be explained while referring to equivalent circuits for specific examples of reactances and resistances.

Fig. 9A is a simplified equivalent circuit diagram which simulates a high frequency operation of the conventional optical semiconductor device shown in Fig. 18. In Fig. 9A, reference symbol 31 denotes the output impedance of the LD driving circuit, 309 denotes a matching resistor, and 310 denotes the internal resistance of the LD. Reference symbol 329 is the wire bond that connects pads, not shown in Fig. 9A, provided on the conductor line electrically connected to the matching resistor 309 to the cathode of the LD 310. Reference symbol 32 denotes the bias circuit including the inductance element 311 such as the solenoid. Although the resistances should actually be reactances, the resistances are shown for simplifying explanation of fundamental passing characteristics in Figs. 9A, 9B, 10A and 10B.

Fig. 9B is a graph which illustrates a simulation result of the frequency response characteristics of this equivalent circuit. Fig. 9B illustrates the simulation result when the output impedance Z1 of the LD driving circuit side is 50 ohms, the internal resistance r1 of the LD 310 is 8 ohms, the resistance R3 of the matching resistor 309 is 40 ohms, the inductance L of the wire bond 329 is 0.5 nanohenries, and the impedance of the bias circuit 32 is 50 ohms. Fig. 9B demonstrates that a 3-decibel band (between m1 and m2 where the frequency is lower by 3 decibels than that of m1) is at about 10.6 gigahertz.

Fig. 10A is a simplified equivalent circuit diagram which simulates the high frequency operation of the optical semiconductor device (differential lines) according to the present invention shown in Fig. 1. In Fig. 10A, reference symbol 31 denotes the output impedance of the LD driving circuit, 19a and 19b denote the matching resistors, 20 denotes the LD, 29 denotes the wire bond, and 32 and 33 denote the respective bias circuits.

Fig. 10B is a graph which illustrates a simulation result of the frequency response characteristics of this equivalent circuit. Fig. 10B illustrates the simulation result when the output impedance Z1 of the LD driving circuit side is 100 ohms, the internal resistance r1 of the LD 20 is 8 ohms, the resistances R3 of the matching resistors 19a and 19b are 40 ohms, the inductance L of the wire bond 29 is 0.5 nanohenry, and the impedances of the bias circuits 32 and 33 are 50 ohms. Fig. 10B demonstrates that a 3-decibel band (between m3 and m4 where the frequency is lower by 3 decibels than that of m3) is at about 18.6 gigahertz.

The substrate side (anode) of the LD element is fixed to a feed line by soldering or the like. Therefore, the inductance component on the LD module side is mainly caused by the wire bond on the cathode side of the LD element, and there is hardly a difference in impedance component between the differential feed circuit and the singe-phase feed circuit. On the other hand, the circuit that employs the differential lines of the impedance viewed from the LD element side is about twice as high as that of the single-phase feed circuit. As a result, by using the differential lines, the frequency characteristics (passing characteristics) are improved.

As can be understood, by connecting the LD driving circuit to the LD module using the differential lines, the frequency characteristics can be improved.

FOURTH EMBODIMENT

Fig. 11A is a circuit diagram which illustrates the configuration of the bias circuits in the equivalent circuit shown in Fig. 10A in detail. Since the configuration and operation of this equivalent circuit are the same as those explained in the first embodiment, they will not be explained herein. In this fourth embodiment, the characteristics of the equivalent circuit in the first embodiment will be explained while referring to specific examples of inductances, capacitances, and resistances.

(FIRST SPECIFIC EXAMPLE)

Pieces of data on the respective elements of the equivalent circuit of the optical semiconductor device in the first specific example are as follows if using symbols shown in Fig. 11A. Resistances R1 and R2 of the resistors 22a and 22b are 1,000 ohms, resistances R3 and R4 of the matching resistors 19a and 19b are 40 ohms, inductances L1 and L2 of the solenoids 21a and 21 b are 0.5 nanohenry, inductances L4 and L5 of the wire bonds 23a and 23b are 3 nanohenries, the resistance Z1 of the LD driving circuit side is 100 ohms, the resistance r1 of the LD 20 is 8 ohms, and parasitic capacitances C1, C2, C3, and C4 of the bias circuits are 0.1 picofarad. Fig. 11 B is a graph which illustrates a simulation result of the frequency characteristics based on these circuit conditions.

Fig. 11C is a circuit block diagram which illustrates the configuration of the bias circuits in the equivalent circuit shown in Fig. 9A in detail. Since the configuration and operation of this equivalent circuit are the same as those explained in the conventional art, they will not be explained herein. Pieces of data on the respective elements of the equivalent circuit are as follows if using symbols shown in Fig. 11C. R2 is 1,000 ohms, R3 is 40 ohms, the inductance L2 of the inductance element 311 is 100 nanohenries, L3 = 0.5 nanohenry, L5 = 3 nanohenries, and the parasitic capacitances C2 and C4 of the bias circuits are 0.1 picofarad. Fig. 11 D is a graph which illustrates a simulation result of the frequency characteristics based on these circuit conditions.

As shown in the simulation results of Fig. 11 B and Fig. 11 D, if the optical semiconductor device employs the differential feed type bias circuits, the amplitude of the resonance ripple caused by the bias circuits can be reduced, as compared with the device that employs the single-phase feed type bias circuits. The result of Fig. 11 B corresponds to that of Fig. 4A which illustrates the experimental result of the differential feed type optical semiconductor device in the first embodiment, and that of Fig. 11 D corresponds to that of Fig. 21 which illustrates the experimental result of the single-phase feed type optical semiconductor device. It is noted, however, that the experimental results of Fig. 4A and Fig. 21 include the frequency characteristics of the LD driving circuits 1 and 200 and a high frequency region is cut off.

Japanese Patent Application Laid-Open Publication No. 5-37083 discloses the circuit in which a ground surface of a feed-through of the package is removed so as to reduce parasitic capacitances outside of the wall surface of the package of the optical module with a view of improving the resonance ripple which occurs due to the capacitances of the bias circuit. This circuit, however, employs a single-phase line and differs in circuit configuration from that of the present invention.

(SECOND SPECIFIC EXAMPLE)

The characteristics of the bias circuits if different conditions are set for the equivalent circuit of the optical semiconductor device in the first embodiment, will be explained as the second specific example of the inductances, capacitances, and resistances.

Fig. 12A is a circuit block diagram which illustrates the identical equivalent circuit to that shown in Fig. 11A. Fig. 12B is a graph which illustrates a simulation result based on circuit conditions shown in Fig. 12A, and corresponds to the graph shown in Fig. 11 B. Fig. 12C is a graph which illustrates a simulation result of the frequency response characteristics when the inductance L4 of the wire bond 23a (or 23c) is changed from 3 nanohenries to 1 nanohenry.

As shown in the simulation results of Fig. 12B and Fig. 12C, by making the inductance components of the wire bond connecting the bias circuit to the LD element and the like asymmetric vertically, a frequency at which the resonance ripple occurs can be set high. Although the amplitude of the ripple increases, a region in which the ripple occurs can be forced out of the band. Therefore, this is advantageous when a desired band is to be secured.

(THIRD SPECIFIC EXAMPLE)

The characteristics of the bias circuits if different conditions are set for the equivalent circuit of the optical semiconductor device in the first embodiment, will be explained as the third specific example of inductances, capacitances, and resistances.

Fig. 13A is a circuit block diagram which illustrates the identical equivalent circuit to that shown in Fig. 11A. Fig. 13B is a graph which illustrates a simulation result based on circuit conditions shown in Fig. 13A, and corresponds to the graph shown in Fig. 11 B. Fig. 13C is a graph which illustrates a simulation result of the frequency response characteristics when the inductance L1 of the solenoid 21 a is changed in the equivalent circuit of Fig. 11A. As regards the solenoid 21 a and the resistance 22a, Fig. 13B is the graph before the inductance L1 is changed while setting L1 = 100 nanohenries and R1 = 1,000 ohms, and Fig. 13C is the graph after the inductance L1 is changed while setting L1 = 10 nanohenries and R1 = 400 ohms.

As shown in the simulation results of Fig. 13B and Fig. 13C, by making the impedances of the solenoid 21a (or 21b) and the resistor 22a (or 22b) connected in parallel to each other in the bias circuit asymmetric vertically, the amplitude of the resonance ripple can be further reduced. This is the same in content as that shown in the experimental result of Fig. 4B which illustrates the first embodiment. In the experimental result of Fig. 4B which illustrates the first embodiment, the frequency characteristics of the LD driving circuit 1 are included and the high frequency region is cut off.

As can be seen, according to the fourth embodiment, by connecting the LD driving circuit to the LD module using the differential lines, the amplitude of the resonance ripple can be reduced. In addition, by making the inductance components of the wire bonds connecting the bias circuits to the LD element and the like asymmetric vertically by changing the lengths of the wire bonds and the like, the frequency at which the resonance ripple occurs can be set high. Further, by making the impedances of the inductance element and the resistance connected in parallel to each other in the bias circuit asymmetric vertically, the amplitude of the resonance ripple can be further reduced.

FIFTH EMBODIMENT

An optical semiconductor element module in the fifth embodiment of the present invention will first be explained with reference to Fig. 14 to Fig. 16.

Fig. 14 illustrates the outside configuration of the optical semiconductor element module (hereinafter, "LD module" since an example of mounting the LD will be mainly explained in this fifth embodiment) 103 which includes a can package 101 and a receptacle 102. Fig. 15(a) and Fig. 15(b) are a horizontal sectional view (a view of a surface parallel to x shown in Fig. 14) and a vertical sectional view (a view of a surface parallel to y shown in Fig. 14) of the LD module 103, respectively.

As shown in Fig. 14 and Figs. 15A and 15B, the can package 101 includes a disk-like stem 110 on which bias feed pins (144a, 144b), high frequency signal pins (141a, 141b), and the like are mounted, a trapezoidal pedestal 111 (a pedestal block) on which a plurality of ceramic substrates are mounted, the condenser lens 25 which condenses a laser light emitted from the LD 20, a cylindrical cap 113 which airtight seals the pedestal 111 and the like from the outside, and the like.

As shown in Figs. 15A and 15B, the cap 113 has a double cylinder form which includes a first cap member 113a fixed to the stem 110 by projection welding or the like and a second cap member 113b fitted into a tip end side of the first cap member 113a from outward and fixed to the first cap member 113a by YAG welding or the like. Specifically, the first cap member 113a includes stepped outer cylinders, and the outer cylinder having a smaller diameter is provided on the tip end of the outer cylinder having a larger diameter. An inner cylinder of the one end-side second cap member 113b is fitted into the outer periphery of the outer cylinder having the smaller diameter, and the first cap member 113a is fixed to the second cap member 113b by through YAG welding.

On the tip end side of the first cap member 113a, a lens insertion hole 114 is formed and the condenser lens 25 is inserted into this hole 114. The condenser lens 25 is fixed to the first cap member 113a by a screw, an adhesive material, or the like. An internal space 115 of the first cap member 113a is isolated from the outside by a glass window 116, whereby the internal space 115 in which the pedestal 111 is contained is kept airtight. If the internal space 115 can be kept airtight by bonding or soldering the condenser lens 25, the window 116 may be omitted.

In a portion (the other end side) of the second cap member 113b opposite to the condenser lens 25, a hole 117 for causing the laser light to pass through is formed. By making an adjustment to position this second cap member 113 relative to a laser light axis direction and fixing the second cap member 113b to the first cap member 113a by the YAG welding, the condenser lens 25 and a dummy ferrule 118 held in the receptacle 102 are aligned to each other in the laser light axis direction.

The receptacle 102 includes a ferrule insertion hole 119 for inserting a ferrule 121 (see Fig. 14) to which an optical fiber 120 is connected, and holds the optical fiber 120. The dummy ferrule 118, in which an optical fiber 118a is arranged, is press-fitted and fixed into a can package 101-side in the ferrule insertion hole 119. One end face of the receptacle 102 on the side, on which the dummy ferrule 118 is fixed, is fixed to an end face on the other end side of the second cap member 113b is fixed to an end face of the other end side of the second cap member 113b in the can package 101 by butt welding using YAG welding or the like. By making a positioning adjustment relative to two directions vertical to the laser light axis direction when fixing the receptacle 102 to the second cap member 113b, the condenser lens 25 is aligned to the dummy ferrule 118 in the receptacle 102 relative to the two directions at right angles with respect to the laser light axis.

The ferrule 121 to which the optical fiber 120 is connected, includes an appropriate mechanism (not shown) for pressing the ferrule 121 toward the dummy ferrule 118 and locking the ferrule 121 to the receptacle 102 when the ferrule 121 is inserted into the ferrule insertion hole 119 of the receptacle 102. Therefore, if the ferrule 121 is inserted into the ferrule insertion hole 119 of the receptacle 102, an end face of the optical fiber 118a in the dummy ferrule 118 abuts on an end face of the optical fiber 120 in the ferrule 121, whereby the fibers are connected (optically coupled) to each other.

The internal configuration of the can package 101 will next be explained. Fig. 16 is a perspective view which illustrates the can package 101 in a state in which the cap 113 is detached.

As shown in Fig. 16, the can package 101 includes the disk-like stem 110 on which a plurality of pins are mounted and the trapezoidal pedestal 111 vertically fixed to an inner wall surface of the stem 110 by Ag brazing or the like

On the stem 110 which constitutes a ground, a pair of high frequency signal pins 141a and 141b to which the differential modulated electric signals (hereinafter, also referred to as "differential high frequency signals") are transmitted from the LD driving circuit 1, two ground pins 142a and 142b arranged on both sides of these high frequency signal pins 141a and 141b, one monitor signal pin 143 for transmitting a signal of a monitoring light reception element (e.g., a photodiode, (hereinafter, "PD")) 150, a pair of bias feed pins 144a and 144b for supplying bias currents from an external DC bias current source to the LD 20, and a PD chip carrier 145 are mounted. For example, if a positive-phase current signal $I_2$ shown in Fig. 16 is extracted from the high frequency signal pin 141a, a current $I_1$ opposite in phase to the current signal $I_2$ shown in Fig. 16 is applied to the high frequency signal pin 141b.

Among these signal pins, the high frequency signal pins 141a and 141b and the ground pins 142a and 142b constitute a feed-through for causing an electric signal to pass through via the stem 110 while being kept airtight. The respective pins are fixed to the stem 110 through dielectrics made of such a material as glass in an airtight sealed state. The ground pins 142a and 142b are fixedly attached to an outer wall surface of the stem 110 that constitutes the ground by press-fitting or welding. The PD 150 mounted on the PD chip carrier 145 is intended to monitor a monitor light emitted from the LD 20 toward a backward direction.

Micro-strip differential line substrates 146 and 147, an LD chip carrier 148, and a bias circuit substrate 149 are mounted on an upper surface of the pedestal 111. A ground conductor layer that is a plane conductor plate formed on rear surfaces of the micro-strip differential line substrates 146 and 147 and the LD chip carrier 148 to function as the ground is coupled to the upper surface of the pedestal 111 by soldering or the like and electrically connected thereto. In addition, the pedestal 111 acts as a radiation path for radiating a heat generated from the LD 20 or the like.

The micro-strip differential line substrate 146 includes a ceramic substrate 151, a pair of strip differential signal lines 152a and 152b formed on an upper surface of the ceramic substrate 151, and the ground conductor layer (not shown) formed on the rear surface of the ceramic substrate 151. Pads 153a and 153b to contact with the high frequency signal pins 141a and 141b protruding from the stem 110 are formed on one-end sides of the strip differential signal lines 152a and 152b, respectively. Capacitive stubs 154a and 154a for impedance matching which protrude to be closer to each other signal line are formed halfway along the strip differential signal lines 152a and 152b, respectively. The strip differential signal lines 152a and 152b are set to have a larger distance therebetween in input-side portions near the stem 110 so as to correct an impedance of the field-through section the impedance of which tends to be low. The strip differential signal lines 152a and 152b each include a portion in which the distance between the signal lines is gradually smaller and an output-side portion in which the distance between the signal lines is close and in which the signal lines are arranged in parallel. End portions of the high frequency signal pins 141a and 141b mounted on the stem 110 are connected and fixed to the pads 153a and 153b of the micro-strip differential line substrate 146 by brazing or soldering.

The micro-strip differential line substrate 147 includes a ceramic substrate 155, a pair of strip differential signal lines 156a and 156b formed on an upper surface of the ceramic substrate 155, and the ground conductor layer (not shown) formed on a rear surface of the ceramic substrate 155. Each of the strip differential signal lines 156a and 156b includes a corner curve portion for turning up a signal line direction by about 90 degrees. The matching resistors 19a and 19b for impedance matching are formed halfway along the strip differential signal lines 156a and 156b, respectively. The strip differential signal lines 152a and 152b are connected to the strip differential signal lines z 156a and 156b by wire bonds 157a and 157b, respectively.

The LD chip carrier 148 includes micro-strip differential lines including a ceramic substrate 158, a pair of strip differential signal lines 159a and 159b formed on an upper surface of the ceramic substrate 158, and the ground conductor layer (not shown) formed on a rear surface of the ceramic substrate 158. The LD 20 is mounted on one end of one strip differential signal line 159b on the LD chip carrier 148 so that the anode that is one of the electrodes of the LD 20 directly abuts on one end thereof. The cathode that is the other electrode of the LD 20 is connected to one end of the other strip differential signal line 159a by the wire bond 29. The strip differential signal lines 156a and 156b are connected to the other ends of the strip differential signal lines 159a and 159b by wire bonds 161a and 161b, respectively. The ceramic substrate 158 is made of a material having good thermal conductivity such as aluminum nitride (AIN) or silicon carbide (SiC). As the LD 20, a distributed feedback laser diode element capable of transmitting a modulated signal at 10 Gb/s, for example, is employed.

Two wiring patterns 162a and 162b and a pair of inductance circuits (parallel circuits each including the inductance element and the resistor) are formed on the bias circuit (ceramic) substrate 149. The solenoid 21a and the resistor 22a that prevents a resonance between an inter-line capacitance of the solenoid 21a and the inductance are arranged to be electrically connected to each other in parallel on the one wiring pattern 162a. The solenoids 21a and 21b are arranged to be away from each other so that (extension lines of) central axes of the solenoids 21a and 21b cross each other, preferably are orthogonal to each other to prevent the solenoids 21a and 21b from interfering with each other magnetic field. One end portion of the wiring pattern 162a and that of the wiring pattern 162b are connected to the strip line differential signal lines 159a and 159b through wire bonds 23a and 23b, respectively. The other end portion of the wiring pattern 162a and that of the wiring pattern 162b are connected to the bias feed pins 144a and 144b provided on the stem 110 through wire bonds 163a and 163b, respectively.

The characteristic configuration of each section in the can package 101 will be explained in more detail. The configuration of the stem 110 will first be explained.

As shown in Fig. 16, the differential high frequency signals output from the differential transistors 12 and 13 in the LD driving circuit 1 are input to the can package 101 through a grounded coplanar differential line 170 provided on a substrate arranged outside of the can package 101. The grounded coplanar differential line 170 includes a pair of differential signal lines 171a and 171b formed on a substrate, grounds 172a and 172b arranged outside of the differential signal lines 171a and 171b to put the paired differential signal lines 171a and 171b therebetween, and the ground conductor layer (not shown) arranged on a rear surface of the line 170 and connected to the grounds 172a and 172b. The differential signal lines 171a and 171b are connected to output terminals 160a and 160b provided on the upper surface of the LD driving circuit 1. The output terminal 160a is electrically connected to the collector of the differential transistor 13 whereas the output terminal 160b is electrically connected to the collector of the differential transistor 12.

The differential signal lines 171a and171b of the grounded coplanar differential line 170 are connected and fixed to the high frequency signal pins 141a and 141b provided on the stem 110 by soldering, respectively. The grounds 172a and 172b of the grounded coplanar differential line 170 are connected and fixed to the ground pins 142a and 142b provided on the stem 110 by soldering, respectively. Further, since there is a gap between a can package-side end face of the grounded coplanar differential line 170 and the stem 110, the reflection of the high frequency signals due to the lowering of the impedances may be suppressed by filling this gap with a dielectric.

The stem 110 includes metal such as Kovar (Fe-Ni alloy), soft iron, or CuW (cupper-tungsten), and an upper layer of the stem 110 is normally plated with Ni, gold or the like for soldering. A plurality of holes 174, 175, 176a, and 176b are formed to be distributed on the stem 110, and dielectrics 177, 178, 179a, and 179b are inserted into the respective holes 174, 175, 176a, and 176b.

A pair of pin insertion holes 180a and 180b are formed in the dielectric 177, and the high frequency signal pines 141a and 141b are inserted into and fixed to the pin insertion holes 180a and 180b, respectively. Likewise, holes (reference symbols of which are not shown) are formed in the dielectrics 178, 179a, and 179b, and the monitor signal pin 143 and the bias feed pins 144a and 144b are inserted into and fixed to the holes, respectively. The dielectric 177 into which the paired high frequency signal pines 141a and 141b are inserted has an oval form in this example. Accordingly, the hole 174 into which the dielectric 177 is inserted has an oval form. The other dielectric 178, 179a, and 179b are circular. It is noted that the ground pins 142a and 142b are fixedly attached to an outer wall surface, not shown, of the stem 110 by press-fitting and welding.

Lengths of portions of the two high frequency signal pins 141a and 141b which protrude toward at least one outside of the dielectric 177 (protruding lengths toward the LD 20 side) are set smaller than those of the monitor signal pin 143 and the bias feed pins 144a and 144b in light of high frequency characteristics. By so setting, the signal transmitted over the high frequency signal pins 141 a and 141 b can be promptly transferred to the strip differential signal lines 152a and 152b on the micro-strip differential line substrate 146 when the signals are out of the dielectric 177. Since the monitor signal pins 143 and the bias feed pins 144a and 144b have no strict restrictions for the high frequency characteristics, the protruding lengths are secured to some extent, thereby facilitating wire bond connection operation and the like.

As a material for the dielectrics 177, 178, 179a, and 179b, Kovar glass, for example, is preferably used or borosilicate glass may be used. As a material for the high frequency signal pins 141a and 141b, the monitor signal pin 143, the bias feed pins 144a and 144b, and the ground pins 142a and 142b, metal such as Kovar or 50-percent Ni-Fe alloy is used.

The grounded coplanar differential line 170, the high frequency signal pins 141 a and 141 b, the ground pins 142a and 142b, the wire bonds 157a and 157b, and the micro-strip differential line substrates 146 and 147 constitute the distributed constant circuit 18.

In the fifth embodiment, in order to make impedance matching from the outputs of the differential transistors 12 and 13 in the LD driving circuit 1 to the LD 20, the paths among them are all constituted by the differential lines to drive the LD 20. In addition, as for the pins penetrating the stem 110, by penetrating the paired high frequency signal pins 141a and 141b through the oval dielectric 177, they act as the differential pins constituting the differential lines. In, for example, the single-phase driving type optical semiconductor device, since a high current that drives the LD 20 is fed back to the LD driving circuit through the ground, the ground potential changes. This ground potential change often adversely affects the optical reception electronic circuit arranged proximate to the device and detecting the feeble current.

In this embodiment, the optical semiconductor device performs the push-pull operation with respect to the LD 20 using the differential lines. Therefore, the optical semiconductor device in this embodiment has advantages in that the high current is carried across the differential lines, the ground potential has less change, and peripheral circuits are less influenced.

As can be seen, the pin exposure region on the LD driving circuit 1-side is constituted to have the differential lines and the ground pins 142a and 142b are arranged outside of the region, to thereby set the impedance of this section lower than that in the conventional optical semiconductor device. Therefore, the difference in impedance between this section and the feed-through section is small, as compared with the conventional art and discontinuity of the electric field is reduced, and the passing characteristics and reflection characteristics can be thereby improved.

The glass is used as the dielectric 177 arranged around the high frequency signal pins 141a and 141b. Therefore, in the inner section of the stem (the feed-through section in which the high frequency signal pins 141a and 141b are surrounded by the dielectric 177, hereinafter, also referred to as "unexposed region"), if the high frequency signal pins 141a and 141b each having a diameter of about 3.5 millimeters to 6 millimeters at which the pins can be handled easily are provided, and the holes of arbitrary shapes are formed in the stem 110 having a diameter of about 3.5 millimeters to 6 millimeters, then the impedance of the inner section tends to be extremely lowered. To increase the impedance of this pin unexposed region, a cross-sectional area of the dielectric 177 arranged around the high frequency pins (an area of the oval) may be set large. If so, however, the optical semiconductor device cannot satisfy requirements for microfabrication and space saving.

Therefore, the protruding lengths of the two high frequency signal pins 141a and 141b toward the LD 20 are set small so that they can be promptly transferred to the strip differential signal lines 152a and 152b on the micro-strip differential line substrate 146 when the signals are out of the dielectric 177. In addition, the distance between the strip differential signal lines 152a and 152b on the micro-strip differential line substrate 146 in the portions which are connected to the high frequency signal pins 141 a and 141 b, respectively and which are closer to the stem 110 are set larger than the distance therebetween in, for example, the portions closer to the micro-strip line substrate 147, or set slightly larger than the distance between the high frequency signal pins 141a and 141b. By thus setting the distance relatively large, the electrical coupling in the portions is made low and the portions are set to have higher impedances.

As can be understood, the distance between the lines in the differential line portions right after the lines are out of the stem 110 is set large to thereby purposely create the high impedance portion. The impedance is cancelled by this high impedance portion and the low impedance portion inside of the stem (in the pin unexposed region), whereby impedance matching is made as a whole. In other words, since the pin unexposed region (feed-through section) is low in impedance, the impedance matching is made in the overall device by slightly generating a high impedance after the region.

In addition, the paired stubs 154a and 154b for impedance matching are formed halfway along the strip differential signal lines 152a and 152b, respectively. The impedance is reduced by the paired stubs 154a and 154b, thereby preventing occurrence of mismatching between the strip differential signal lines 152a and 152b and the strip differential lines 156a and 156b, respectively. In other words, by using the paired stubs 154a and 154b, the reactance components in the driver-side pin exposed region and those in the pin unexposed region (feed-through section) are compensated for each other, and the passing characteristics and the reflection characteristics are thereby improved.

In this case, the paired stubs 154a and 154b protrude not outward but inward (so as to be closer to each other signal line), which, therefore, contributes to microfabrication of the micro-strip differential line substrate 146. If it is unnecessary to make the micro-strip differential line substrate 146 small in size, the stubs 154a and 154b may protrude outward of the differential lines 152a and 151b.

In the can package 101, it is necessary to arrange the differential line substrates for connecting the high frequency signal pins 141a and 141b to the LD 20, the bias circuit substrate for supplying the DC bias currents to the LD 20, and the monitor PD 50.

If so, the micro-strip differential line substrates 146 and 147 and the bias circuit substrate 149 are arranged on the both sides of the LD chip carrier 148 to put the LD chip carrier 148 therebetween. In other words, while the LD 20 is put at the center, the strip differential signal lines 152a and 152b on the micro-strip differential line substrate 146 and the strip differential signal lines 156a and 156b on the micro-strip differential line substrate 147, the wiring patterns 162a and 162b including a pair of inductance circuits, and the LD 20 are arranged generally in a U-shaped fashion.

Furthermore, the micro-strip differential line substrates 146 and 147 are provided at the positions shifted sideways from the LD chip carrier 148. Naturally, therefore, the transparent dielectric 177 for sealing and fixing the high frequency signal pins 141 a and 141 b is provided at the position shifted sideways from the LD chip carrier 148.

There is a technique for constituting the substrate on which the LD 20 is mounted and the differential line substrates for connecting the high frequency signal pins 141a and 141b to the LD 20 out of the same substrate. With this technique, however, a substrate material, such as a aluminum nitride substrate (AIN), expensive per unit area and having good radiation characteristics needs to be used in a wide area so as to radiate the heat from the LD 20 that serves as a heat source. This causes a cost hike.

To avoid such a cost hike, the LD chip carrier 148 on which the LD 20 serving as the heat source is mounted is separated from the other substrates and provided as an independent substrate. Thanks to this, it suffices to use the ceramic substrate material, such as the aluminum nitride substrate (AIN), which is expensive and which has good radiation characteristics only for the LD chip carrier 148 and to use the ceramic substrate material, such as inexpensive $Al_2O_3$ for the other substrates (the micro-strip differential line substrates 146 and 147, and the bias circuit substrate 149). Thus, cost reduction can be realized.

Moreover, according to this embodiment, the micro-strip differential line substrate 146 for impedance matching and the micro-strip differential line substrate 147 for arranging the matching resistors 19a and 19b are provided as separate substrates. Therefore, it is possible to cut out the ceramic substrates economically, thereby contributing to cost reduction.

Additionally, the parallel circuit connected to the bias feed pins 144a and 144b and including the solenoid 21a and the resistor 22a and the parallel circuit including the solenoid 21 b and the resistor 22b are arranged on the bias circuit substrate 149, thereby reducing the area of the bias circuit substrate. This can, therefore, contribute to cost reduction and microfabrication.

A thickness of the dielectric 177 is set smaller than a depth of the hole 174 formed in the stem 110, i.e., a width of the stem 110, and a hole 195 having an LD-side opening portion formed conically is formed in the stem 110.

In this embodiment, the grounded coplanar differential line may be employed in place of the micro-strip differential line substrates 146 and 147. As already explained, the grounded coplanar differential line includes the paired differential signal line formed on the substrate, the grounds arranged outside of the differential signal lines so as to put the paired differential signal lines therebetween, and the ground conductor layer arranged on the rear surface of the substrate.

SIXTH EMBODIMENT

The optical semiconductor element module in the sixth embodiment of the present invention will be explained with reference to Figs. 17A and 17B. Fig. 17(A) is a top view of the optical semiconductor element module in a state in which an upper cap 401 is detached, and Fig. 17(B) is a cross-sectional view taken along II of Fig. 17(A) (note, however, that Fig. 17(B) is in a state in which the upper cap 401 is attached).

In this sixth embodiment, the LD 20 mounted on the can package 101 explained in the previous embodiment, various constituent elements including a substrate 501 on which the LD 20 is mounted, and the LD driving circuit 1 are contained in a box-like (butterfly-like) optical semiconductor package 402.

As shown in Figs. 17A and 17B, in this optical semiconductor package 402, the positive-phase and antiphase differential signals are input to the input buffer 11 of the LD driving circuit 1 as already explained. To input the differential signals to the LD driving circuit 1 in the optical semiconductor package 402, the dielectric 177 (feed-through) is fitted into a sidewall of the optical semiconductor package 40, and the differential signals are transmitted through differential lines 178a and 178b provided on the dielectric 177 while keeping an interior and an exterior of the package airtight.

One end of the differential line 178a and that of the differential line 178b are soldered to the high frequency signal pins 141 a and 141b, respectively, outside of the optical semiconductor package 402. The high frequency signal pins 141 a and 141 b are arranged proximate to each other until positions at which the pins 141a and 141b are put between the ground pins 142a and 142b connected to the ground, and constitute the differential lines.

The other ends of the differential lines 178a and 178b are connected to one ends of differential strip lines 411 provided on a substrate 502, respectively. The other ends of the differential strip lines 411 are connected to one ends of differential strip lines provided on a substrate 503. The other ends of the differential strip lines provided on the substrate 503 are connected to differential signal input terminals of the LD driving circuit 1 through wire bonds, respectively, and electrically connected to the input buffer 11 in the LD driving circuit 1.

The output terminals of the LD driving circuit 1 electrically connected to the differential transistors 12 and 13, are connected to one ends of the differential lines provided on a substrate 504 through wire bonds, respectively. The other ends of the differential lines provided on the substrate 504 are connected to one ends of differential lines provided on the substrate 501 through wire bonds, respectively. The anode of the LD 20 is soldered to the other end side of one of the differential lines on the substrate 501 as shown in Fig. 5. The other end side of the other differential line on the substrate 501 is connected to the cathode of the LD 20 through the wire bond as shown in Fig. 5. The matching resistors 19a and 19b are provided on the one end side of the substrate 501. As shown in Fig. 5, the bias circuit 28a in which the solenoid 21a and the resistor 22a are connected in parallel and the bias circuit 28b in which the solenoid 21 b and the resistor 22b are connected in parallel are provided on the substrate 505. The bias circuits 28a and 28b are connected to the differential lines on the substrate 501, respectively. Further, the bias circuits 28a and 28b are connected to conductor lines on a ceramic substrate 450 through wire bonds, respectively.

The bias circuits 28a and 28b are connected to respective conductor leads 451 through wire bonds and the ceramic substrate 450 (feed-through). The ceramic substrate 450 is fitted into the sidewall of the package, and transmits the bias currents and control signals for the LD driving circuit 1 inside and outside of the optical semiconductor package 402 while keeping airtight.

The LD driving circuit 1, and the substrates 501, 503, 504, and 505 are mounted on a metallic conductor mount 510. A lens 520 which includes a lens and a holder that holds the lens is coupled to a side surface of the metallic conductor mount 510. The lens 520 is arranged to condense a light on the optical fiber 120 through the other optical components. Further, the upper cap 401 is welded to an upper surface of the optical semiconductor package 402, and a window glass 600 is coupled to a light pass-through hole in a front sidewall of the optical semiconductor package 402, thereby securing airtightness. The optical fiber 120 is held by an optical fiber holding section 403.

In this sixth embodiment, the differential signals are input to the LD driving circuit 1 using the high frequency signal pins 141 a and 141 b constituting the differential lines, the differential strip lines 411, and the other differential lines. Therefore, similarly to the preceding embodiments, it is possible to suppress the deterioration of the high frequency characteristics and improve airtightness.

As explained so far, in the optical semiconductor device according to the present invention, the optical semiconductor element to which the differential lines are connected is driven by the push-pull operation. Therefore, the optical semiconductor device has advantages in that the asymmetry of the waveform can be improved, the quality of the optical output waveform can be improved, and that the good transmission characteristics can be thereby obtained.

Moreover, in the optical semiconductor device according to the present invention, the bias circuits are arranged on the both electrode sides of the optical semiconductor element to which the differential lines are connected, respectively. Therefore, the optical semiconductor device has advantages in that the ripple of the passing characteristics following the bias circuits can be improved, the quality of the optical output waveform can be improved, and that the good transmission characteristics can be thereby obtained.

INDUSTRIAL APPLICABILITY

As explained so far, the present invention, as the optical semiconductor element having good transmission characteristics or as the optical semiconductor device that includes the optical semiconductor element, is suited to high speed optical communications.

**Claims**

**1.** An optical semiconductor device comprising:

an optical semiconductor element (20) for outputting an optical signal modulated based on an electrical signal ;

a first conductor line connected to one electrode of a pair of electrodes of the optical semiconductor element (20), and supplying an electric signal to the optical semiconductor element (20);

a second conductor line connected to the other electrode of the pair of electrodes of the optical semiconductor element (20), and supplying an electric signal to the optical semiconductor element (20);

wherein the first and the second conductor lines constitute a pair of differential lines; **characterized by**: a first inductance element (21a) connected to the one electrode of the optical semiconductor element (20) and the first conductor line; and a second inductance element (21 b) connected to the other electrode of the optical semiconductor element (20) and the second conductor line.

2. The optical semiconductor device according to claim 1, further comprising a pair of matching resistors connected to the one electrode and the other electrode of the optical semiconductor element (20), respectively, and introducing the electric signals to the optical semiconductor element (20).

3. The optical semiconductor device according to claim 2, comprising a filter (27) that cuts off frequencies higher than at least a maximum repetition frequency of a digital signal, the filter provided between the first and the second conductor lines and the pair of matching resistors.

4. The optical semiconductor device according to claim 3, wherein the filter (27) includes a first conductor finger section and a second conductor finger section in which a plurality of conductors crossing the first and the second conductor lines are formed, respectively, to have a comb shape, the first conductor finger section and the second conductor finger sections being alternately arranged.

5. The optical semiconductor device according to claim 1, 2, 3 or 4, comprising:

a first bias circuit (28a) including the first inductance element (21 a) and a first resistor (22a) connected in parallel to the first inductance element (21 a); and
a second bias circuit (28b) including the second inductance element and a second resistor (22b) connected in parallel to the second inductance element (21 b).

6. The optical semiconductor device according to claim 5, wherein impedances of at least two bias circuits (28a, 28b) are set asymmetric.

7. The optical semiconductor device according to any one of the preceding claims, comprising:

a package (101) containing therein the first and the second conductor lines;
a lens (25) that condenses a light emitted from the optical semiconductor element (20); and
an optical fiber holding member (102) that holds an optical fiber.

8. The optical semiconductor device according to any one of the preceding claims, wherein the first and the second inductance elements (21 a, 21 b) are air-cored coils.

9. The optical semiconductor device according to any one of the preceding claims, wherein the optical semiconductor element (20) is a semiconductor laser diode.

**Patentansprüche**

1. Optisches Halbleiterbauelement, welches aufweist:

ein optisches Halbleiterelement (20) zum Ausgeben eines optischen Signals, das auf der Grundlage eines elektrischen Signals moduliert ist; einen ersten Leiter, der mit einer Elektrode eines Paares von Elektroden des optischen Halbleiterelements (20) verbunden ist und ein elektrisches Signal zu dem optischen Halbleiterelement (20) führt;
einen zweiten Leiter, der mit der anderen Elektrode des Paares von Elektroden des optischen Halbleiterelements (20) verbunden ist und ein elektrisches Signal zu dem optischen Halbleiterelement (20) führt;

wobei der erste und der zweite Leiter ein Paar von Differenzialleitungen bilden; **gekennzeichnet durch**:

ein erstes Induktivitätselement (21a), das mit der einen Elektrode des optischen Halbleiterelements (20) und dem ersten Leiter verbunden ist; und
ein zweites Induktivitätselement (21b), das mit der anderen Elektrode des optischen Halbleiterelements (20) und dem zweiten Leiter verbunden ist.

2. Optisches Halbleiterbauelement nach Anspruch 1, weiterhin aufweisend ein Paar von Anpassungswiderständen, die mit der einen Elektrode bzw. der anderen Elektrode des optischen Halbleiterelements (20) verbunden sind und die elektrischen Signale in das optische Halbleiterelement (20) einführen.

3. Optisches Halbleiterbauelement nach Anspruch 2, aufweisend ein Filter (27), das Frequenzen ausblendet, die höher als zumindest eine maximale Wiederholungsfrequenz eines digitalen Signals sind, wobei das Filter zwischen dem ersten und dem zweiten Leiter und dem Paar von Anpassungswiderständen vorgesehen ist.

4. Optisches Halbleiterbauelement nach Anspruch 3, bei dem das Filter (27) einen ersten Leiterfingerabschnitt und einen zweiten Leiterfingerabschnitt enthält, in denen mehrere Leiter, die den ersten bzw. zweiten Leiter kreuzen, gebildet sind, um eine Kammform aufzuweisen, wobei der erste Leiterfingerabschnitt und der zweite Leiterfingerabschnitt abwechselnd angeordnet sind.

5. Optisches Halbleiterbauelement nach Anspruch 1, 2, 3 oder 4, welches aufweist:

    eine erste Vorspannschaltung (28a) enthaltend das erste Induktivitätselement (21a) und einen ersten Widerstand (22a), der parallel zu dem ersten Induktivitätselement (21a) geschaltet ist; und
    eine zweite Vorspannschaltung (28b), die das zweite Induktivitätselement und einen zweiten Widerstand (22b) enthält, der parallel zu dem zweiten Induktivitätselement (21b) geschaltet ist.

6. Optisches Halbleiterbauelement nach Anspruch 5, bei dem Impedanzen von zumindest zwei Vorspannschaltungen (28a, 28b) asymmetrisch eingestellt sind.

7. Optisches Halbleiterbauelement nach einem der vorhergehenden Ansprüche, welches aufweist:

    eine Baueinheit (101) enthaltend den ersten und den zweiten Leiter;
    eine Linse (25), die von dem optischen Halbleiterelement (20) emittiertes Licht bündelt; und
    ein Halteteil (102) für eine optische Faser, das eine optische Faser hält.

8. Optisches Halbleitervorrichtung nach einem der vorhergehenden Ansprüche, bei dem das erste und das zweite Induktivitätselement (21a, 21b) Spulen mit Luftkern sind.

9. Optisches Halbleitervorrichtung nach einem der vorhergehenden Ansprüche, bei dem das optische Halbleiterelement (20) eine Halbleiter-Laserdiode ist.

## Revendications

1. Dispositif à semi-conducteur optique comprenant

    un élément à semi-conducteur optique (20) pour fournir un signal optique modulé sur la base d'un signal électrique
    une première ligne conductrice connectée à une première électrode d'une paire d' électrodes de l'élément à semi-conducteur optique (20), et fournissant un signal électrique à l'élément à semi-conducteur optique (20) ;
    une seconde ligne conductrice connectée à une seconde électrode de la paire d'électrodes de l'élément à semi-conducteur optique (20), et fournissant un signal électrique à l'élément à semi-conducteur optique (20) ;

    dans lequel les première et seconde lignes conductrices constituent une paire de lignes différentielles ;
    **caractérisé par** :

    un premier élément d'inductance (21a) connecté à la première électrode de l'élément à semi-conducteur optique (20) et à la première ligne conductrice ; et
    un second élément d'inductance (21b) connecté à la seconde électrode de l'élément à semi-conducteur optique (20) et à la seconde ligne conductrice.

2. Dispositif à semi-conducteur optique selon la revendication 1, comprenant en outre une paire de résistances d'adaptation connectées à la première électrode et à la seconde électrode de l'élément à semi-conducteur optique (20), respectivement, et introduisant les signaux électriques dans l'élément à semi-conducteur optique (20).

3. Dispositif à semi-conducteur optique selon la revendication 2, comprenant un filtre (27) qui coupe les fréquences supérieures à au moins une fréquence de répétition maximum d'un signal numérique, le filtre étant prévu entre les première et seconde lignes conductrices et la paire de résistances d'adaptation.

4. Dispositif à semi-conducteur optique selon la revendication 3, dans lequel le filtre (27) comprend une première section de doigts conducteurs et une seconde section de doigts conducteurs dans lesquelles une pluralité de conducteurs croisant les première et seconde lignes conductrices sont formés, respectivement, pour avoir une forme de peigne, la première section de doigts conducteurs et la seconde section de doigts conducteurs étant agencées alternativement.

5. Dispositif à semi-conducteur optique selon la revendication 1, 2, 3 ou 4, comprenant :

    un premier circuit de polarisation (28a) comprenant le premier élément d'inductance (21a) et une première résistance (22a) connectée en parallèle au premier élément d'inductance (21a) ; et
    un second circuit de polarisation (28b) comprenant le second élément d'inductance et une seconde résistance (22b) connectée en parallèle au second élément d'inductance (21b).

6. Dispositif à semi-conducteur optique selon la revendication 5, dans lequel les impédances d'au moins deux circuits de polarisation (28a, 28b) sont prévues pour être asymétriques.

7. Dispositif à semi-conducteur optique selon l'une quelconque des revendications précédentes, comprenant :

    un boîtier (101) contenant les première et seconde lignes conductrices ;
    une lentille (25) qui condense une lumière émise à partir de l'élément à semi-conducteur optique (20) ; et
    un élément de support de fibre optique (102) qui supporte une fibre optique.

8. Dispositif à semi-conducteur optique selon l'une quelconque des revendications précédentes, dans lequel les premier et second éléments d'inductance (21a, 21b) sont des bobines à noyau d'air.

9. Dispositif à semi-conducteur optique selon l'une quelconque des revendications précédentes, dans lequel l'élément à semi-conducteur optique (20) est une diode laser à semi-conducteur.

# FIG.1

ANTIPHASE SIGNAL

POSITIVE-PHASE SIGNAL

INPUT BUFFER 11

12 Tr (TRANSISTOR)

13 Tr (TRANSISTOR)

15 16

14 VD

18 DISTRIBUTED CONSTANT CIRCUIT

19b MATCHING RESISTOR

19a MATCHING RESISTOR

22b RESISTOR

21b SOLENOID

28b

23b

22a RESISTOR

21a SOLENOID

28a

23a

WIRE BOND

20 LD (LASER DIODE)

25

26

29

24 VD₂

LD DRIVING CIRCUIT 1

LD MODULE 2

Vee (NEGATIVE POWER SUPPLY)

Vee (NEGATIVE POWER SUPPLY)

# FIG.2A

REFERENCE
CURRENT

tr    tf

# FIG.2B

$$tf$$

$$\frac{(tr+tf)}{2}$$

$$tr$$

NORMALIZED
AMPLITUDE

1

1

0

EP 1 523 078 B1

# FIG.3

EYE MASK
REGION

EYE PATTERN

F

EP 1 523 078 B1

## FIG.4A

## FIG.4B

# FIG.5

EP 1 523 078 B1

FIG.6A

39    38    41

P

FIG.6B

39

40

# FIG.7

C2
f CHARACTERISTICS WHEN
RINGING IS PRESENT

C1

C3
f CHARACTERISTICS WHEN
FILTER AGAINST RINGING IS
INSERTED

EP 1 523 078 B1

# FIG.8

LD DRIVING CIRCUIT SIDE | LD MODULE SIDE

31 — Z

27 — C

19b — Rd

20 — r

Rd — 19a

## FIG.9A

LD DRIVING CIRCUIT SIDE | LD MODULE SIDE

32

309

329

R3

L3

31 — Z1

310 — r1

## FIG.9B

RESPONSE CHARACTERISTICS (dB)

m1

m2

FREQUENCY (GHz)

# FIG.10A

LD DRIVING          LD MODULE
CIRCUIT SIDE          SIDE

32

19a          29

R3          L3          20

31          Z1          r1

19b

R4

33

# FIG.10B

FIG.11A

FIG.11B

FIG.11C

FIG.11D

FIG.12B

## FIG.12A

EP 1 523 078 B1

BEFORE CHANGE

## FIG.12C

AFTER CHANGE

LD DRIVING CIRCUIT SIDE

LD MODULE SIDE

CHANGE OF INDUCTANCE PARAMETER

# FIG.13A

LD DRIVING CIRCUIT SIDE | LD MODULE SIDE

CHANGE OF INDUCTANCE PARAMETER

# FIG.13B

BEFORE CHANGE

# FIG.13C

AFTER CHANGE

EP 1 523 078 B1

# FIG.14

Fig. 15A

142b
141b
177
141a
143
142a
144a
144b

110

195
111
101
116
114
117
102
103
119

150 113a 20
25 113b
118a
118

Fig. 15B

143
144a,144b
141a,141b
170
177

110

115
103

20
150

111 113a
25 113b
102

EP 1 523 078 B1

FIG.16

FIG.17A

FIG.17B

# FIG.18

ANTIPHASE SIGNAL

POSITIVE-PHASE SIGNAL

202
Tr (TRANSISTOR)

203
Tr (TRANSISTOR)

P

200

VD○ 204

Vee
(NEGATIVE POWER SUPPLY)

300

310
LD (LASER DIODE)

316

Q

309

311

LD MODULE

VD₂○ 314

Vee
(NEGATIVE POWER SUPPLY)

EP 1 523 078 B1

# FIG.19

EYE PATTERN

0%

10%

90%

100%

Tr
(RISE TIME)

Tf
(FALL TIME)

EP 1 523 078 B1

# FIG.20

EYE MASK REGION

W1  W2

EYE PATTERN

EP 1 523 078 B1

# FIG.21

EP 1 523 078 B1